# EUROPEAN PATENT APPLICATION

(11) **EP 2 816 606 A1**
(43) Date of publication of application: **24.12.2014**
(21) Application number: 14172259.5
(22) Date of filing: 13.06.2014
(51) Int. Cl.: H01L 29/778, H01L 23/29, H01L 29/207, H01L 23/31, H01L 29/417, H01L 29/20

(54) **Semiconductor device and manufacturing method thereof**

(30) Priority: 13.06.2013 JP 2013124992; 21.04.2014 JP 2014087724
(71) Applicant: FUJITSU LIMITED, Kawasaki-shi, Kanagawa 211-8588 (JP)
(72) Inventor: Kamada, Youichi, Kawasaki-shi, Kanagawa 211-8588 (JP); Ozaki, Shirou, Kawasaki-shi, Kanagawa 211-8588 (JP); Ohki, Toshihiro, Kawasaki-shi, Kanagawa 211-8588 (JP); Makiyama, Kozo, Kawasaki-shi, Kanagawa 211-8588 (JP); Okamoto, Naoya, Kawasaki-shi, Kanagawa 211-8588 (JP)
(74) Representative: Reichl, Philipp

(57) **Abstract**

A semiconductor device includes a first semiconductor layer (21) formed of a nitride semiconductor on a substrate (11); a second semiconductor layer (22) formed of a nitride semiconductor on the first semiconductor layer; an insulation film (30) including an opening, and being formed on the second semiconductor layer; a source electrode (42) and a drain electrode (43) formed on the second semiconductor layer; and a gate electrode (41) formed at the opening on the second semiconductor layer. Both the insulation film and the second semiconductor layer include carbon in a neighborhood of an interface between the insulation film and the second semiconductor layer.

## Description

### FIELD

The disclosures herein generally relate to a semiconductor device and a manufacturing method thereof.

### BACKGROUND

Nitride semiconductors such as GaN, AlN, and InN, or mixed crystals of these materials have wide band gaps, and are used as high-output electronic devices, short-wavelength light-emitting devices, and the like. For example, GaN, which is a nitride semiconductor, has the band gap of 3.4 eV, which is greater than the band gap of 1.1 eV of Si and the band gap of 1.4 eV of GaAs.

To be used as high-output devices, technologies relating to field-effect transistors (FET), especially, high electron mobility transistors (HEMT), have been developed (see, for example, Patent Document 1). A HEMT that uses such a nitride semiconductor is used for a high-output, a high-efficiency amplifier, a high-power switching device, or the like. Specifically, in a HEMT that uses AlGaN in an electron supply layer and GaN in an electron transit layer, piezoelectric polarization or the like is generated in AlGaN due to distortion caused by different lattice constants between AlGaN and GaN, and high-density 2DEG (Two-Dimensional Electron Gas) is generated. Therefore, such a HEMT can operate at high voltage, and can be used for a high-efficiency switching element, a high-voltage resistance electric power device for an electric vehicle and the like.

### [Related-Art Documents]

### [Patent Documents]

[Patent Document 1] Japanese Laid-open Patent Publication No. 2002-359256

Incidentally, there is a type of the HEMT described above that has a structure in which an insulation film having an opening is formed on a nitride semiconductor, and a gate electrode is formed on the insulation film at the opening and its neighborhood. In a HEMT having such a structure, there are cases where a gate leakage current becomes comparatively great.

Therefore, a semiconductor device having a low gate leakage current has been desired that has a structure in which an insulation film having an opening is formed on a nitride semiconductor, and a gate electrode is formed on the insulation film at the opening and its neighborhood.

### SUMMARY

According to at least an embodiment of the present invention, a semiconductor device includes a first semiconductor layer (21) configured to be formed of a nitride semiconductor on a substrate (11); a second semiconductor layer (22) configured to be formed of a nitride semiconductor on the first semiconductor layer; an insulation film (30) configured to include an opening (30a), and to be formed on the second semiconductor layer; a source electrode (42) and a drain electrode (43) configured to be formed on the second semiconductor layer; and a gate electrode (41) configured to be formed at the opening on the second semiconductor layer. Both the insulation film and the second semiconductor layer include carbon in a neighborhood of an interface between the insulation film and the second semiconductor layer.

Also, according to at least another embodiment of the present invention, a semiconductor device includes a first semiconductor layer (21) configured to be formed of a nitride semiconductor on a substrate; a second semiconductor layer (22) configured to be formed of a nitride semiconductor on the first semiconductor layer; a third semiconductor layer (23) configured to be formed of a nitride semiconductor on the second semiconductor layer; an insulation film (30) configured to include an opening (30a), and to be formed on the third semiconductor layer; a source electrode (42) and a drain electrode (43) configured to be formed on the second semiconductor layer; and a gate electrode (41) configured to be formed at the opening on the third semiconductor layer. Both the insulation film and the third semiconductor layer include carbon in a neighborhood of an interface between the insulation film and the third semiconductor layer.

Also, according to at least another embodiment of the present invention, a manufacturing method of a semiconductor device includes forming a first semiconductor layer (21) and a second semiconductor layer (22) made of a nitride semiconductor in order on a substrate (11); carbonizing a surface of the second semiconductor layer; forming an insulation film (30) on the second semiconductor layer; forming an opening (30a) in the insulation film; forming a gate electrode (41) at the opening on the second semiconductor layer; and forming a source electrode (42) and a drain electrode (43) on the second semiconductor layer.

Also, according to at least another embodiment of the present invention, a manufacturing method of a semiconductor device includes forming a first semiconductor layer (21), a second semiconductor layer (22) and a third semiconductor layer (23) made of a nitride semiconductor in order on a substrate (11); carbonizing a surface of the third semiconductor layer; forming an insulation film (30) on the third semiconductor layer; forming an opening (30a) in the insulation film; forming a gate electrode (41) at the opening on the third semiconductor layer; and forming a source electrode (42) and a drain electrode (43) on the second semiconductor layer.

According to at least one of the embodiments of the present invention, a semiconductor device having a low gate leakage current can be obtained that has a structure in which an insulation film having an opening is formed on a nitride semiconductor, and a gate electrode is formed on the insulation film at the opening and its neighborhood.

### BRIEF DESCRIPTION OF DRAWINGS

FIGs. 1A-1B are schematic views of a conventional semiconductor device;
FIGs. 2A-2B are schematic views of a semiconductor device according to a first embodiment;
FIG. 3 is a schematic view of another semiconductor device according to the first embodiment;
FIGs. 4A-4C are first process views illustrating a manufacturing method of a semiconductor device according to the first embodiment;
FIGs. 5A-5B are second process views illustrating the manufacturing method of the semiconductor device according to the first embodiment;
FIGs. 6A-6C are analytical views of a conventional semiconductor device by TEM-EDX;
FIGs. 7A-7C are analytical views of a semiconductor device according to the first embodiment by TEM-EDX;
FIG. 8 is an analytical view of a semiconductor device according to the first embodiment by XPS analysis;
FIG. 9 is a schematic view illustrating a leakage current in a semiconductor device;
FIG. 10 is a schematic view illustrating XPS analysis on a GaN surface;
FIGs. 11A-11C are first process views illustrating a manufacturing method of the semiconductor device according to a second embodiment;
FIGs. 12A-12B are second process views illustrating the manufacturing method of the semiconductor device according to the second embodiment;
FIGs. 13A-13C are first process views illustrating a manufacturing method of a semiconductor device according to a third embodiment;
FIG. 14 is a second process view illustrating the manufacturing method of the semiconductor device according to the third embodiment;
FIG. 15 is a schematic view of a semiconductor device according to a fourth embodiment;
FIGs. 16A-16C are first process views illustrating a manufacturing method of a semiconductor device according to the fourth embodiment;
FIG. 17 is a second process view illustrating the manufacturing method of the semiconductor device according to the fourth embodiment;
FIGs. 18A-18B are schematic views of semiconductor devices having respective drain electrode at different positions;
FIG. 19 is a first correlation view between input power (Pin) and power added efficiency (PAE);
FIG. 20 is a first correlation view between drain voltage Vd and drain current Id of semiconductor devices;
FIG. 21 is a schematic view of a semiconductor device according to a fifth embodiment;
FIG. 22 is a second correlation view between input power (Pin) and power added efficiency (PAE);
FIG. 23 is a second correlation view between drain voltage Vd and drain current Id of semiconductor devices;
FIGs. 24A-24C are first process views illustrating a manufacturing method of a semiconductor device according to the fifth embodiment;
FIGs. 25A-25C are second process views illustrating the manufacturing method of the semiconductor device according to the fifth embodiment;
FIGs. 26A-26C are third process views illustrating the manufacturing method of the semiconductor device according to the fifth embodiment;
FIG. 27 is a schematic view of a semiconductor device according to a sixth embodiment;
FIG. 28 is a third correlation view between input power (Pin) and power added efficiency (PAE);
FIG. 29 is a third correlation view between drain voltage Vd and drain current Id of semiconductor devices;
FIGs. 30A-30C are first process views illustrating a manufacturing method of a semiconductor device according to a sixth embodiment;
FIGs. 31A-31C are second process views illustrating the manufacturing method of the semiconductor device according to the sixth embodiment;
FIGs. 32A-32C are third process views illustrating the manufacturing method of the semiconductor device according to the sixth embodiment;
FIGs. 33A-33C are first process views illustrating a manufacturing method of a semiconductor device according to a seventh embodiment;
FIGs. 34A-34C are second process views illustrating the manufacturing method of the semiconductor device according to the seventh embodiment;
FIGs. 35A-35B are third process views illustrating the manufacturing method of the semiconductor device according to the seventh embodiment;
FIG. 36 is a schematic view of a semiconductor device according to an eighth embodiment;
FIG. 37 is a circuit diagram of a PFC circuit according to the eighth embodiment;
FIG. 38 is a circuit diagram of a power source device according to the eighth embodiment; and
FIG. 39 is a circuit diagram of a high-output amplifier according to the eighth embodiment.

### DESCRIPTION OF EMBODIMENTS

In the following, embodiments of the present invention will be described with reference to the drawings. Note that the same numerical codes are assigned to the same members, and their description may be omitted.

### [First embodiment]

First, a reason will be described why a leakage current becomes high in a semiconductor device that has a structure in which an insulation film having an opening is formed on a nitride semiconductor, and a gate electrode is formed on the insulation film at the opening and its neighborhood.

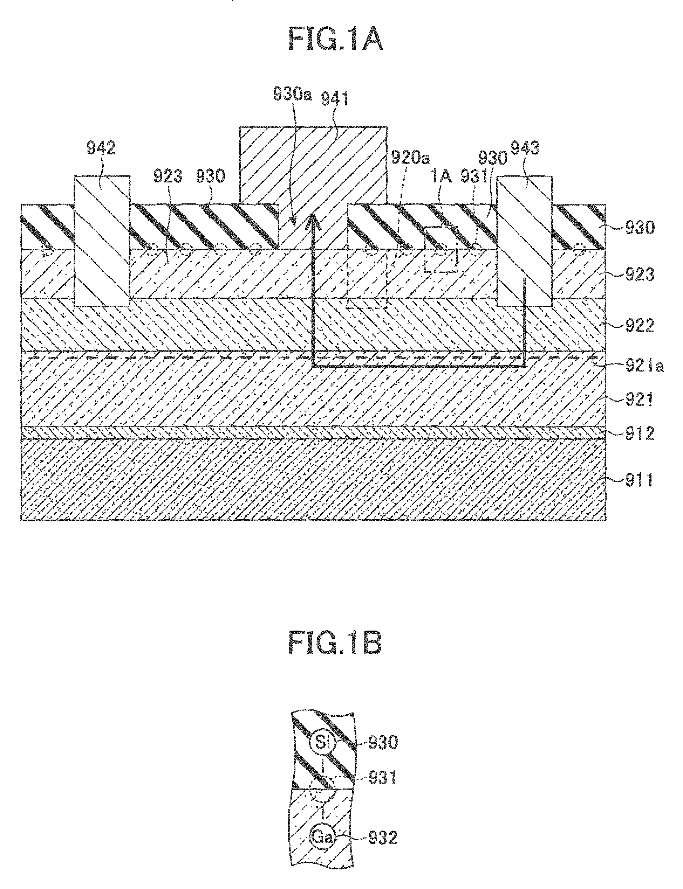

FIG. 1A is a structural view of a HEMT that is a semiconductor device that has a structure in which an insulation film having an opening is formed on a nitride semiconductor, and a gate electrode is formed on the insulation film at the opening and its neighborhood. As illustrated in FIG. 1A, the HEMT has layers formed on a substrate 911 made of SiC, Si or the like that include a buffer layer 912, an electron transit layer 921, an electron supply layer 922, and a cap layer 923, which are stacked in this order and formed by epitaxial growth.

The buffer layer 912 includes a nucleation layer, and is formed of AlN, AlGaN, or the like. The electron transit layer 921 is formed of i-GaN, the electron supply layer 922 is formed of AlGaN, and the cap layer 923 is formed of GaN. With this structure, 2DEG 921a is generated in the neighborhood of the interface between the electron supply layer 922 and the electron transit layer 921 in the electron transit layer 921. An insulation film 930 having an opening 930a is provided on the cap layer 923, and a gate electrode 941 is formed at the opening 930a on the cap layer 923 and on the insulation film 930 in the neighborhood of the opening 930a. Also, a source electrode 942 and a drain electrode 943 are formed on the electron supply layer 922 that is exposed by removing the cap layer 923. Note that the insulation film 930 is formed of silicon oxide (SiO₂) or silicon nitride (SiN).

At the interface between the cap layer 923 and the insulation film 930, as illustrated in FIG. 1B, there are dangling bonds of Ga in the cap layer 923 and dangling bonds of Si in the insulation film 930. If such dangling bonds exist at the interface between the cap layer 923 and the insulation film 930, traps 931 are formed with holes or electrons at the interface between the cap layer 923 and the insulation film 930. If such traps 931 are formed, a depletion layer 920a does not extend enough to a region where the 2DEG 921a is generated due an influence of the traps 931 even if a voltage is applied to turn off the gate electrode 941. This makes it easier for a gate leakage current to flow via the 2DEG 921a.

Therefore, if the traps 931 are not formed at the interface between the cap layer 923 and the insulation film 930, the gate leakage current can be decreased. Namely, if the dangling bonds of Ga in the cap layer 923 and the dangling bonds of Si in the insulation film 930 do not exist, the gate leakage current can be decreased.

Note that although the described semiconductor device in FIG. 1A has the structure in which the cap layer 923 is formed, it is substantially the same as a semiconductor device having a structure in which the insulation film 930 is formed on the electron supply layer 922 without forming the cap layer 923.

### (Semiconductor device)

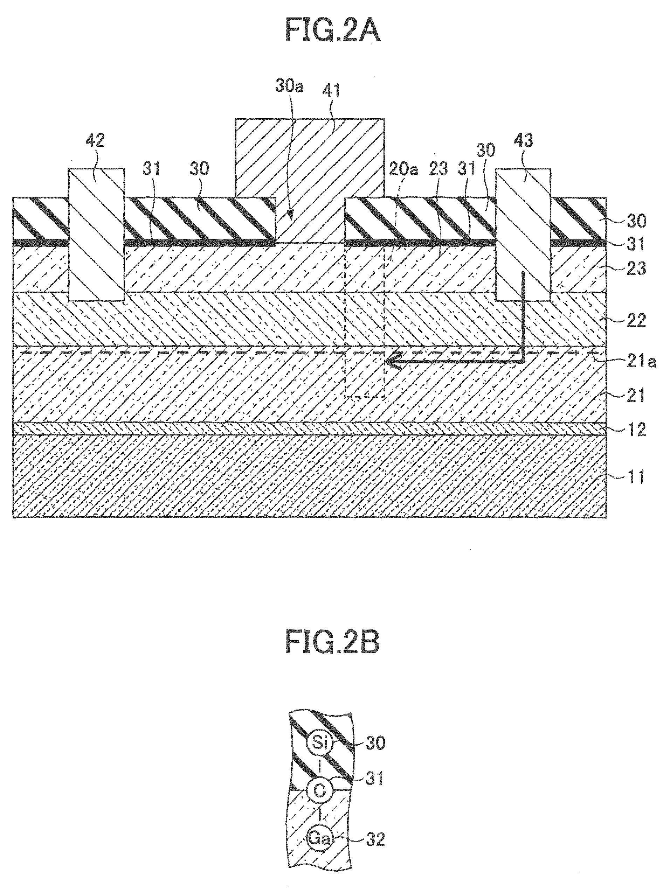

Next, a semiconductor device will be described according to a first embodiment of the present invention based on FIG. 2A. The semiconductor device in the present embodiment has layers formed on a substrate 11 made of SiC, Si or the like that include a buffer layer 12, an electron transit layer 21, an electron supply layer 22, and a cap layer 23, which are stacked in this order and formed by epitaxial growth. Note that are there cases in the present embodiment in which the electron transit layer 21 is referred to as a first semiconductor layer, the electron supply layer 22 is referred to as a second semiconductor layer, and the cap layer 23 is referred to as a third semiconductor layer. Also note that there are cases where a nitride semiconductor refers to a nitride semiconductor layer that includes stacked layers of an electron transit layer 21 and an electron supply layer 22, or stacked layers of an electron transit layer 21, an electron supply layer 22 and a cap layer 23.

The buffer layer 12 includes a nucleation layer, and is formed of AlN, AlGaN, or the like. The electron transit layer 21 is formed of i-GaN, the electron supply layer 22 is formed of AlGaN, and the cap layer 23 is formed of GaN. With this structure, 2DEG 21a is generated in the neighborhood of the interface between the electron supply layer 22 and the electron transit layer 21 in the electron transit layer 21. An insulation film 30 having an opening 30a is provided on the cap layer 23, and a gate electrode 41 is formed at the opening 30a on the cap layer 23 and on the insulation film 30 in the neighborhood of the opening 30a. Also, a source electrode 42 and a drain electrode 43 are formed on the electron supply layer 22 that is exposed by removing the cap layer 23. Note that the insulation film 30 is formed of silicon oxide (SiO₂ or silicon nitride (SiN).

In the semiconductor device according to the present embodiment, carbon (C) 31 is included in the cap layer 23 and the insulation film 30 in the neighborhood of the interface between the cap layer 23 and the insulation film 30. This makes, as illustrated in FIG. 2B, Ga in the cap layer 23 and Si in the insulation film 30 be bonded with C, which makes the number of dangling bonds of Ga in the cap layer 23 and dangling bonds of Si in the insulation film 30 extremely small. By reducing the dangling bonds in this way, the traps due to holes or electrons in the neighborhood of the interface between the cap layer 23 and the insulation film 30 can be reduced or eliminated. With the reduced or eliminated traps, if a voltage is applied to the gate electrode 41 to turn it off, a depletion layer extends enough to a region where the 2DEG 21a is generated, which reduces the gate leakage current via the 2DEG 921a.

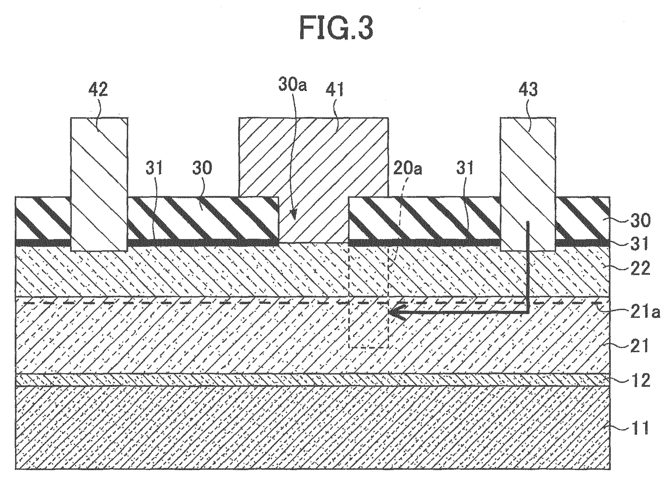

Note that, in the present embodiment, as will be described later, heat treatment is applied in an atmosphere of carbonic acid gas or the like while the cap layer 23 is in an exposed state so that carbon (C) 31 is included in the neighborhood of the interface between the cap layer 23 and the insulation film 30. Also note that although the semiconductor device in FIG. 2A is described with the structure in which the cap layer 23 is formed, it is substantially the same as a semiconductor device having a structure in which the insulation film 30 is formed on the electron supply layer 22 without forming the cap layer 23. Specifically, as illustrated in FIG. 3, the semiconductor device may be formed to have a structure in which the insulation film 30 is formed on the electron supply layer 22 without forming the cap layer 23 so that carbon (C) 31 is included in the neighborhood of the interface between the electron supply layer 22 and the insulation film 30. To have carbon (C) 31 included in the neighborhood of the interface between the electron supply layer 22 and the insulation film 30, the semiconductor device may be subjected to heat treatment in an atmosphere of carbonic acid gas or the like while the electron supply layer 22 is in an exposed state. For manufacturing the semiconductor device having the structure illustrated in FIG. 3, a process to form the cap layer 23 can be omitted in a manufacturing method of the semiconductor device described later.

Note that although the above case is described where the insulation film 30 is made of SiN, the insulation film 30 may include one of SiO₂, SiC, SiON, SiCN, SiCO, AlN, Al₂O₃, and AlON. Also, the insulation film 30 may not be a single-layer film, but a multi-layer film where layers are made of different materials. Specifically, the insulation film 30 may be a multi-layer film that is made of two or more materials selected among SiN, SiO₂, SiC, SiON, SiCN, SiCO, AlN, Al₂O₃, and AlON.

Also note that although the above case is described where the electron supply layer 22 is made of AlG an electron supply layer 22 may be formed of a material including InAlN and InGaAlN.

### (Manufacturing method of semiconductor device)

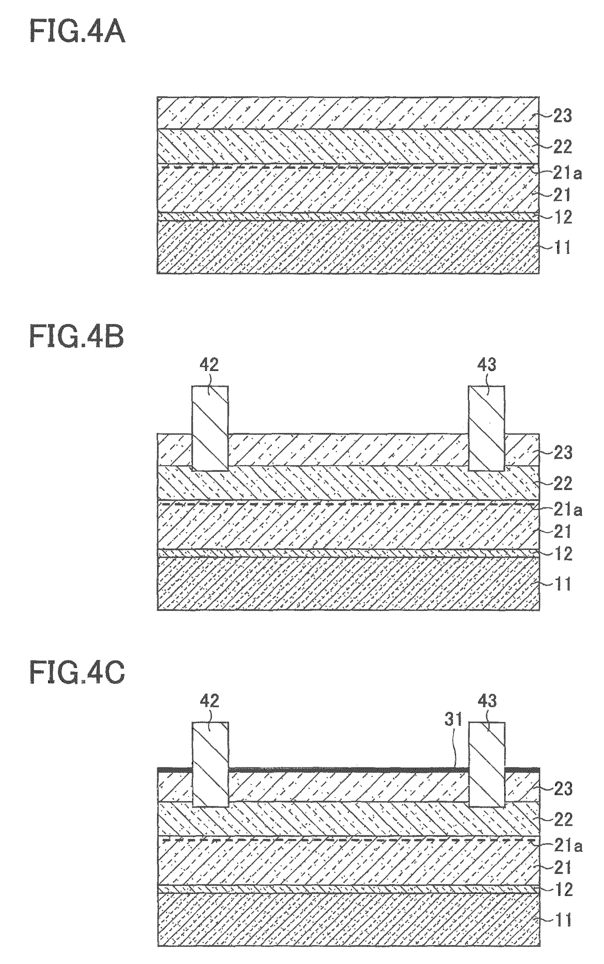

Next, a manufacturing method of the semiconductor device in the present embodiment will be described based on FIGs. 4A-5B.

First, as illustrated in FIG. 4A, layers are formed on a substrate 11 that include a buffer layer 12, an electron transit layer 21, an electron supply layer 22, and a cap layer 23 by epitaxial growth using MOVPE (Metal Organic Vapor Phase Epitaxy). Note that the substrate 11 is formed of SiC or the like, the electron transit layer 21 is formed of i-GaN, the electron supply layer 22 is formed of n-AlGaN, and the cap layer 23 is formed of n-GaN. With this structure, 2DEG 21a is generated in the neighborhood of the interface between the electron supply layer 22 and the electron transit layer 21 in the electron transit layer 21. Also, a spacer layer made of i-AlGaN may be formed between the electron transit layer 21 and the electron supply layer 22 (not illustrated).

Next, as illustrated in FIG. 4B, a source electrode 42 and a drain electrode 43 are formed on the electron supply layer 22. Specifically, by applying photoresist on the surface of the cap layer 23, which is then exposed by an exposure device and developed, a photoresist pattern (not illustrated) is formed that has openings in regions where the source electrode 42 and the drain electrode 43 are to be formed. After that, the cap layer 23 is removed in the regions where the photoresist pattern is not formed, by dry etching such as RIE (Reactive Ion Etching) that uses a chlorine-based gas as an etching gas. At this moment, a part of the electron supply layer 22 may be removed. After that, a stacked metal film made of Ti/Al is formed on the surface where the photoresist pattern is formed by vacuum deposition, and then, by dipping into an organic solvent or the like, the stacked metal film formed on the photoresist pattern is removed by liftoff, along with the photoresist pattern. Thus, the source electrode 42 and the drain electrode 43 are formed with the remaining stacked metal film.

Next, as illustrated in FIG. 4C, heat treatment is applied in a hydrocarbon gas or a carbonic acid gas atmosphere at a temperature of 400 °C to 1000 °C. The heat treatment makes the source electrode 42 and the drain electrode 43 have ohmic contacts, and carbonizes the surface of the cap layer 23 to attach C with n-GaN. In the present embodiment, carbonization is performed in a mixed gas atmosphere of carbon dioxide and nitrogen. Note that, in the present embodiment, there are cases where carbonization refers to heat treatment in a hydrocarbon gas or a carbonic acid gas atmosphere at a temperature of 400 °C to 1000 °C. Also, carbonization may be performed in an atmosphere including one of carbon dioxide, carbon monoxide, methane, ethane, and ethylene. With the carbonization, Ga and C can be bonded in the neighborhood of the surface of the cap layer 23, which reduces dangling bonds of Ga in the neighborhood of the surface of the cap layer 23.

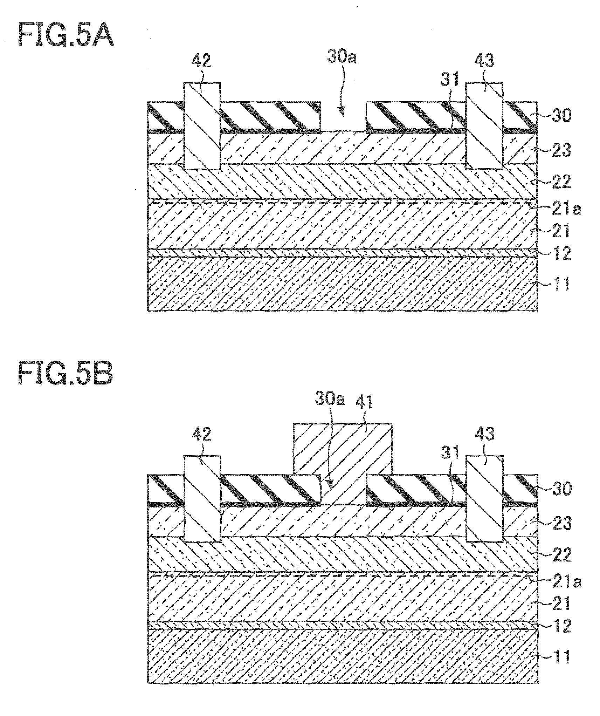

Next, as illustrated in FIG. 5A, the insulation film 30 is formed on the cap layer 23 that has an opening 30a at a region where a gate electrode 41 is to be formed. Specifically, the insulation film 30 is formed by forming a film of SiN that has the thickness of 10 nm to 100 nm on the cap layer 23, by using plasma CVD (Chemical Vapor Deposition). This bonds Si and C that are included in the insulation film 30 in the neighborhood of the interface between the cap layer 23 and the insulation film 30. Note that the insulation film 30 is formed to have the thickness of about 40 nm in the present embodiment. After that, by applying photoresist on the formed insulation film 30, which is then exposed by an exposure device and developed, a photoresist pattern (not illustrated) is formed that has an opening in the region where the opening 30a is to be formed. After that, by dry etching such as RIE that uses a fluorine-based gas as an etching gas, the insulation film 30 is removed in the region where the photoresist pattern is not formed so that the cap layer 23 is exposed, and the opening 30a is formed in the insulation film 30. After that, the photoresist pattern (not illustrated) is removed by an organic solvent or the like.

Next, as illustrated in FIG. 5B, the gate electrode 41 is formed in a predetermined region at the opening 30a on the cap layer 23 and on the insulation film 30 in the neighborhood of the opening 30a. Specifically, by applying photoresist on the insulation film 30 and the cap layer 23 exposed at the opening 30a, which is then exposed by an exposure device and developed, a photoresist pattern (not illustrated) is formed that has an opening in the region where the gate electrode 41 is to be formed. After that, a stacked metal film made of Ni/Au is formed on the surface where the photoresist pattern is formed by vacuum deposition, and then, by dipping into an organic solvent or the like, the stacked metal film formed on the photoresist pattern is removed by liftoff, along with the photoresist pattern. Thus, the gate electrode 41 is formed with the remaining stacked metal film at the opening 30a on the cap layer 23 and on the insulation film 30 in the neighborhood of the opening 30a.

Thus, the semiconductor device can be manufactured according to the present embodiment.

### (Analysis and characteristics of semiconductor device)

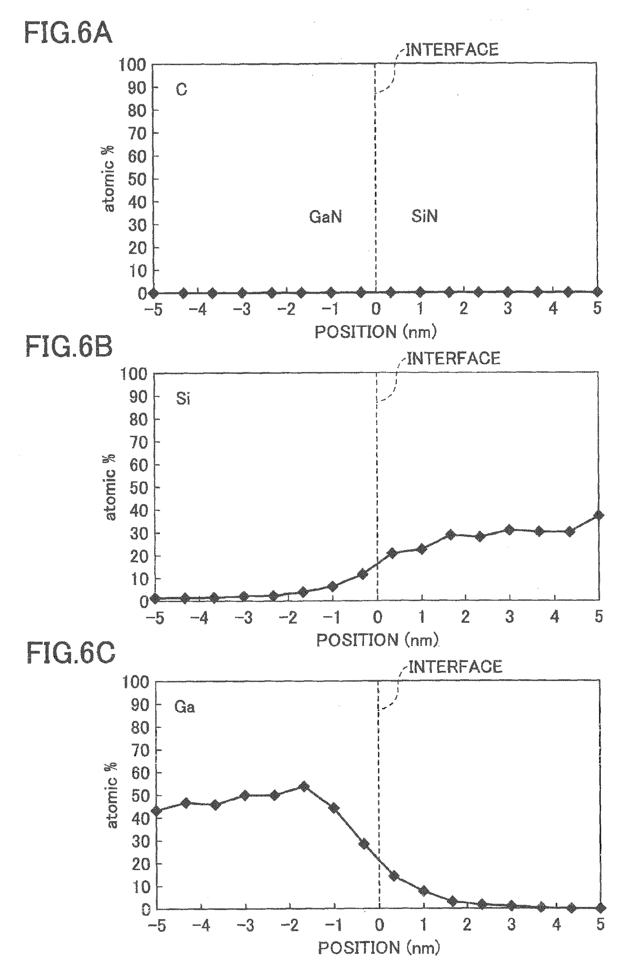

Next, a result of analysis will be described that is obtained by using TEM (Transmission Electron Microscope)-EDX (Energy dispersive X-ray spectrometry), based on FIGs. 6A-7C. Specifically, the analysis with TEM-EDX is performed on a semiconductor device having the structure illustrated in FIG. 1A, and a semiconductor device in the present embodiment.

FIGs. 6A-6C illustrate the result of analysis obtained by using TEM-EDX in the neighborhood of the interface between the cap layer 923 formed of GaN and the insulation film 930 formed of SiN in the semiconductor device having the structure illustrated in FIG. 1A. FIGs. 6A, 6B, and 6C illustrate the compositions of C (carbon), Si, and Ga, respectively, in the neighborhood of the interface between the cap layer 923 formed of GaN and the insulation film 930 formed of SiN.

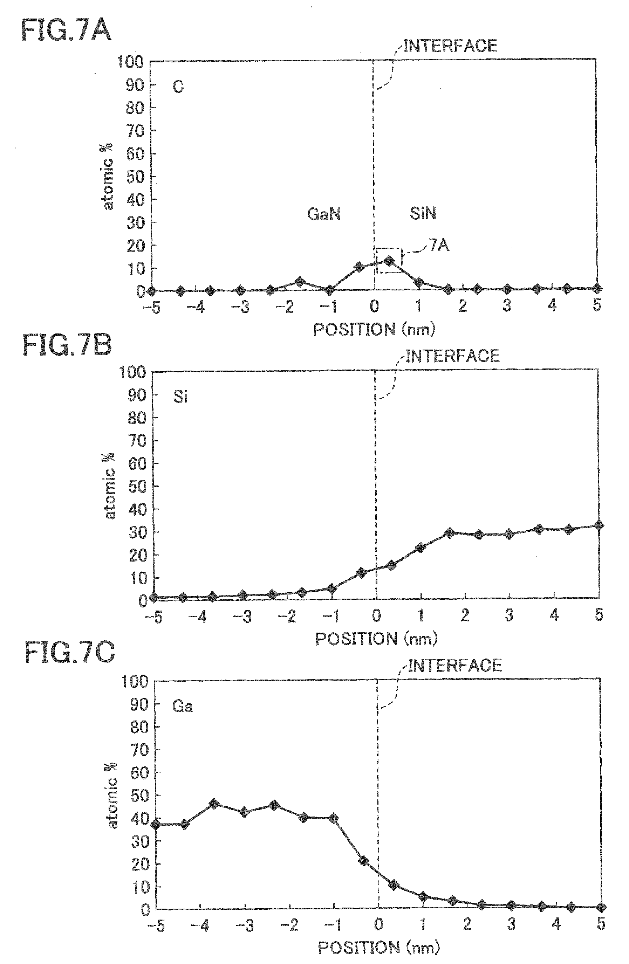

FIGs. 7A-7C illustrates the result of analysis obtained by using TEM-EDX in the neighborhood of the interface between the cap layer 23 formed of GaN and the insulation film 30 formed of SiN in the semiconductor device having the structure illustrated in FIG. 1A. FIGs. 7A, 7B, and 7C illustrate the compositions of C (carbon), Si, and Ga, respectively, in the neighborhood of the interface between the cap layer 23 formed of GaN and the insulation film 30 formed of SiN.

As illustrated in FIG. 6A, in the semiconductor device having the structure illustrated in FIG. 1A, C hardly exists in the neighborhood of the interface between the cap layer 923 formed of GaN and the insulation film 930 formed of SiN. On the other hand, as illustrated in FIG. 7A, a greater amount of C exists in the semiconductor device in the present embodiment in the neighborhood of the interface between the cap layer 23 formed of GaN and the insulation film 30 formed of SiN, than in FIG. 6A. As illustrated in FIG. 7A, the density of C included in the cap layer 23 or the insulation film 30 is greater than or equal to 10 atomic% in the neighborhood of the interface between the cap layer 23 and the insulation film 30.

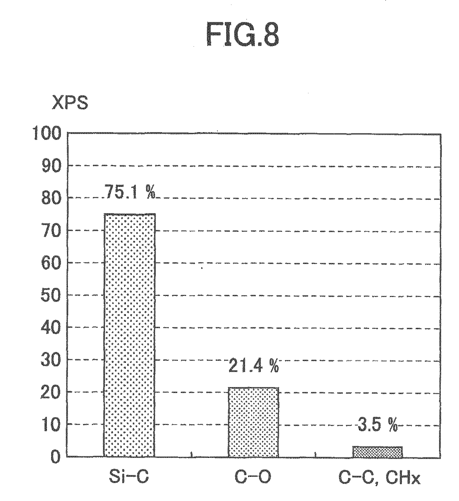

Next, a result of the analysis is illustrated in FIG. 8 where the bonding state of C is obtained at a part enclosed by a dashed-dotted line 7A in FIG. 7A, namely, a part of the insulation film 30 in the neighborhood of the interface between the cap layer 23 and the insulation film 30, by using XPS (X-ray Photoelectron Spectroscopy). Note that FIG. 8 illustrates values quantified by waveform separation of C1s spectrum. As illustrated in FIG. 8, the bonding state of C in the insulation film 30 in the neighborhood of the interface between the cap layer 23 and the insulation film 30 includes 75.1% of Si-C, 21.4% of C-O, and 3.5% of C-C and CHₓ.

Thus, more than 75% of C is in the bonding state with Si in the insulation film 30 in the neighborhood of the interface between the cap layer 23 and the insulation film 30, and Si in the interface of the insulation film 30 is bonded with C, which makes dangling bonds extremely rare for Si. Therefore, according to the present embodiment, dangling bonds can be reduced for the element that forms the insulation film 30 in the neighborhood of the interface between the cap layer 23 and the insulation film 30, by forming the neighborhood of the interface between the cap layer 23 and the insulation film 30 to include C.

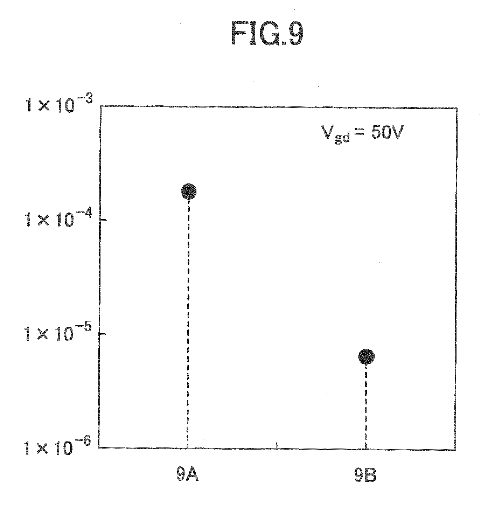

Next, a measurement result of gate leakage currents is illustrated in FIG. 9 that are measured for a semiconductor device having the structure illustrated in FIG. 1A and a semiconductor device in the present embodiment. FIG. 9 illustrates a measurement result of gate leakage currents when a voltage of 50 V is applied between the gate and the drain. A dashed line marked with 9A designates the leakage current of the semiconductor device having the structure illustrated in FIG. 1A, and another dashed line marked with 9B designates the leakage current of the semiconductor device in the present embodiment. The gate leakage current greater than 1x10⁻⁴ A/mm flows in the semiconductor device having the structure illustrated in FIG. 1A as designated by the line 9A, whereas the gate leakage current of less than 1x10⁻⁵ A/mm flows in the semiconductor device according to the present embodiment. Therefore, the semiconductor device according to the present embodiment can reduce the gate leakage current.

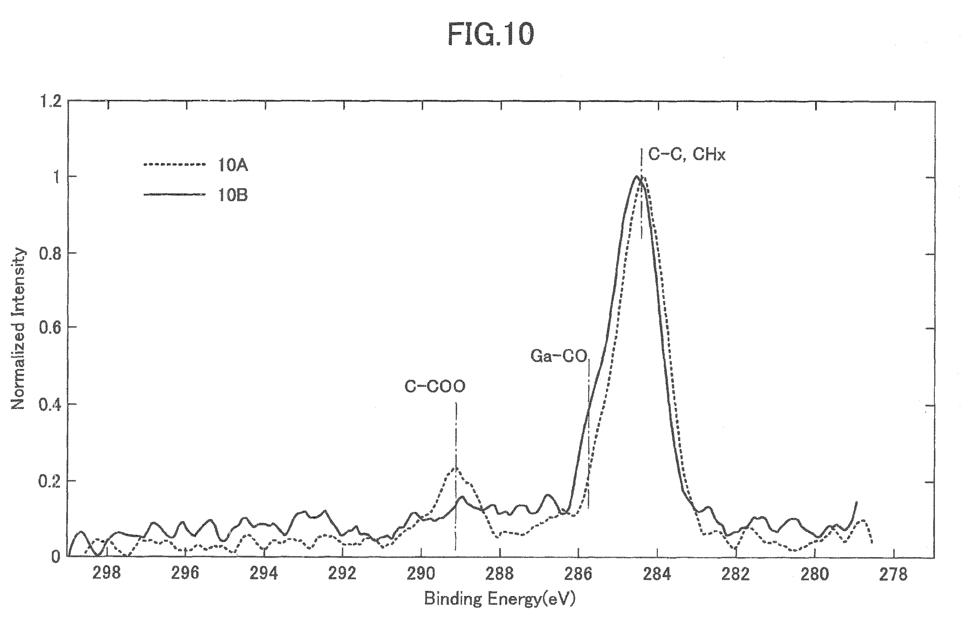

Next, the surface state of the cap layer 23 will be described based on FIG. 10 when the process of carbonization, namely, the process illustrated in FIG. 4C has been performed in the manufacturing method of the semiconductor device according to the present embodiment. FIG. 10 illustrates a result of XPS analysis of the surfaces of the cap layers. Specifically, a dashed line 10A illustrates the result of XPS analysis of the surface of the cap layer 923 in the semiconductor device having the structure illustrated in FIG. 1A, which has not had the carbonization applied. A solid line 10B illustrates the result of XPS analysis of the surface of the cap layer 23 in the semiconductor device according to the present embodiment, which has the carbonization applied.

As illustrated in FIG. 10, the normalized intensity of Ga-CO, which designates the bond between Ga and C, is greater on the line 10B than on the line 10A. This means the carbonization (designated with the line 10B) can increase bonds between Ga and C. Note that, C-COO, C-C or CHₓ are bonds not bonded with Ga, which are considered to be caused by surface contamination. Therefore, these bonds are eliminated by applying heat or the like, and do not contribute to reducing dangling bonds of Ga and Si.

### [Second embodiment]

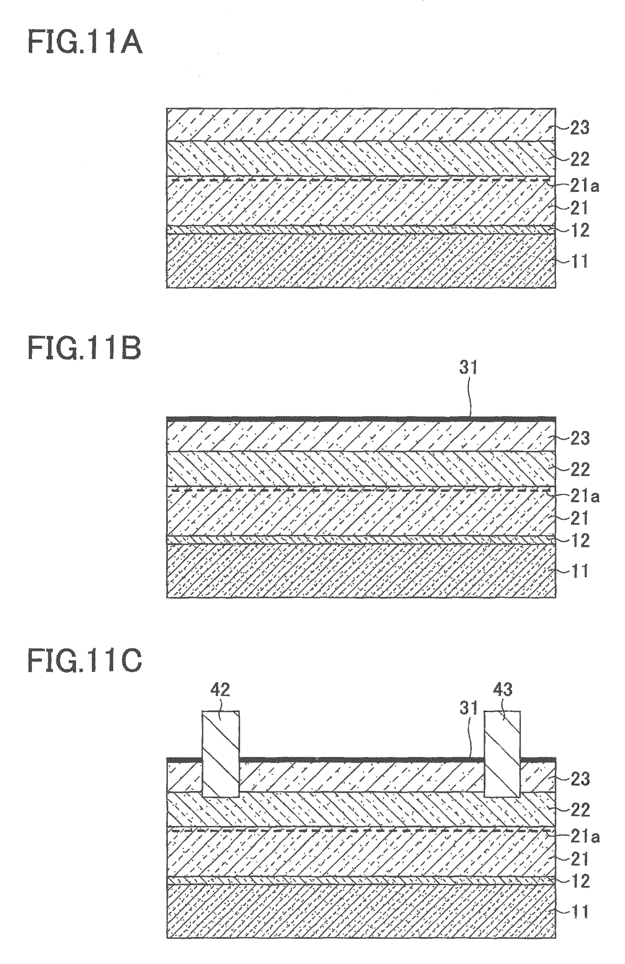

Next, a second embodiment will be described. The present embodiment relates to a manufacturing method of a semiconductor device according to the first embodiment, which is different from the manufacturing method described in the first embodiment. The manufacturing method of a semiconductor device according to the present embodiment will be described based on FIGs. 11A-12B.

First, as illustrated in FIG. 11A, layers are formed on a substrate 11 of SiC or the like that include a buffer layer 12, an electron transit layer 21, an electron supply layer 22, and a cap layer 23 in order, by epitaxial growth using MOVPE. Note that the electron transit layer 21 is formed of i-GaN, the electron supply layer 22 is formed of n-AlGaN, and the cap layer 23 is formed of n-GaN. With this structure, 2DEG 21a is generated in the neighborhood of the interface between the electron supply layer 22 and the electron transit layer 21 in the electron transit layer 21. Also, a spacer layer made of i-AlGaN may be formed between the electron transit layer 21 and the electron supply layer 22 (not illustrated).

Next, as illustrated in FIG. 11B, carbonization is performed by applying heat at a temperature of 400 °C to 1000 °C in a hydrocarbon gas or a carbonic acid gas atmosphere to have n-GaN on the surface of the cap layer 23 attached with C. In the present embodiment, carbonization is performed in a mixed gas atmosphere of carbon dioxide and nitrogen. Carbonization may also be performed in an atmosphere that includes one of carbon dioxide, carbon monoxide, methane, ethane, and ethylene. This process forms bonds between Ga and C in the neighborhood of the surface of the cap layer 23, which reduces dangling bonds of Ga in the neighborhood of the surface of the cap layer 23.

Next, as illustrated in FIG. 11C, a source electrode 42 and a drain electrode 43 are formed on the electron supply layer 22. Specifically, by applying photoresist on the surface of the cap layer 23, which is then exposed by an exposure device and developed, a photoresist pattern (not illustrated) is formed that has openings in regions where the source electrode 42 and the drain electrode 43 are to be formed. After that, the cap layer 23 is removed in the regions where the photoresist pattern is not formed, by dry etching such as RIE that uses a chlorine-based gas as an etching gas. At this moment, a part of the electron supply layer 22 may be removed. After that, a stacked metal film made of Ti/Al is formed on the surface where the photoresist pattern is formed by vacuum deposition, and then, by dipping into an organic solvent or the like, the stacked metal film formed on the photoresist pattern is removed by liftoff, along with the photoresist pattern. Thus, the source electrode 42 and the drain electrode 43 are formed with the remaining stacked metal film on the electron supply layer 22. After that, heat treatment is applied in a nitrogen atmosphere at a temperature of 400 °C to 1000 °C to make the source electrode 42 and the drain electrode 43 have ohmic contacts.

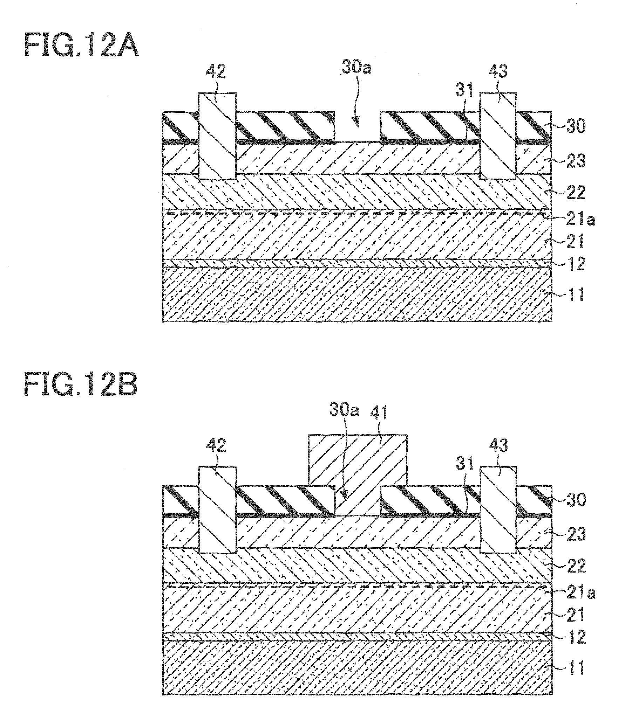

Next, as illustrated in FIG. 12A, the insulation film 30 is formed on the cap layer 23 that has an opening 30a at a region where a gate electrode 41 is to be formed. Specifically, the insulation film 30 is formed by forming a film of SiN that has the thickness of 10 nm to 100 nm on the cap layer 23, by using plasma CVD (Chemical Vapor Deposition). Note that the insulation film 30 is formed to have the thickness of about 40 nm in the present embodiment. This bonds Si and C that are included in the insulation film 30 in the neighborhood of the interface between the cap layer 23 and the insulation film 30. After that, by applying photoresist on the formed insulation film 30, which is then exposed by an exposure device and developed, a photoresist pattern (not illustrated) is formed that has an opening in the region where the opening 30a is to be formed. After that, by dry etching such as RIE that uses a fluorine-based gas as an etching gas, the insulation film 30 is removed in the region where the photoresist pattern is not formed so that the cap layer 23 is exposed, and the opening 30a is formed in the insulation film 30. After that, the photoresist pattern (not illustrated) is removed by an organic solvent or the like.

Next, as illustrated in FIG. 12B, the gate electrode 41 is formed in a predetermined region at the opening 30a on the cap layer 23 and on the insulation film 30 in the neighborhood of the opening 30a. Specifically, by applying photoresist on the insulation film 30 and the cap layer 23 exposed at the opening 30a, which is then exposed by an exposure device and developed, a photoresist pattern (not illustrated) is formed that has openings in the region where the gate electrode 41 is to be formed. After that, a stacked metal film made of Ni/Au is formed on the surface where the photoresist pattern is formed by vacuum deposition, and then, by dipping into an organic solvent or the like, the stacked metal film formed on the photoresist pattern is removed by liftoff, along with the photoresist pattern. Thus, the gate electrode 41 is formed with the remaining stacked metal film at the opening 30a on the cap layer 23 and on the insulation film 30 in the neighborhood of the opening 30a.

Thus, the semiconductor device can be manufactured according to the present embodiment. Note that the content other than described above is substantially the same as in the first embodiment.

### [Third Embodiment]

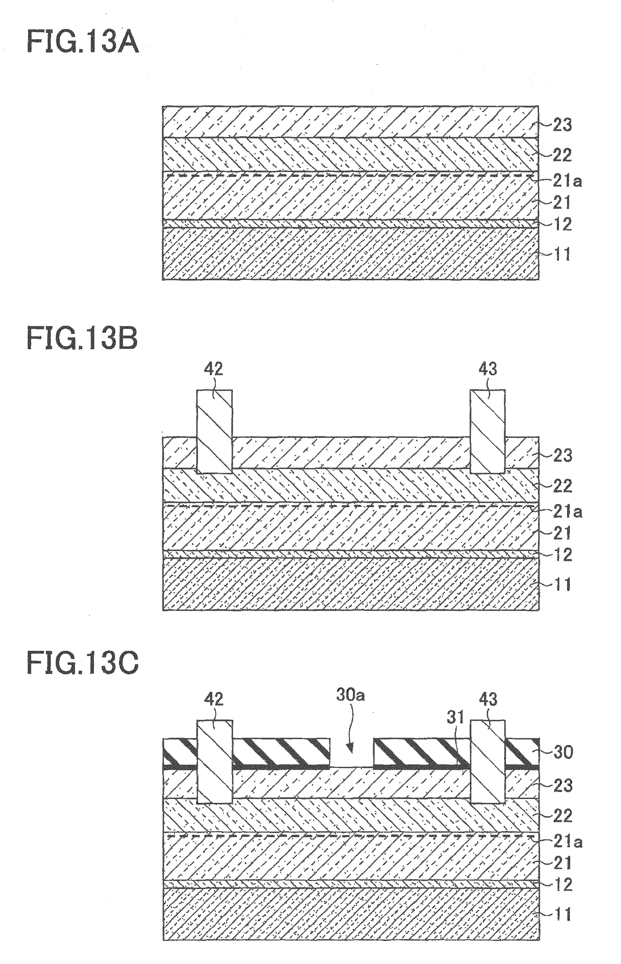

Next, a third embodiment will be described. The present embodiment relates to a manufacturing method of a semiconductor device according to the first embodiment, which is different from the manufacturing methods described in the first and second embodiments. The manufacturing method of a semiconductor device according to the present embodiment will be described based on FIGs. 13A-14.

First, as illustrated in FIG. 13A, layers are formed on a substrate 11 of SiC or the like that include a buffer layer 12, an electron transit layer 21, an electron supply layer 22, and a cap layer 23 in order, by epitaxial growth using MOVPE. Note that the electron transit layer 21 is formed of i-GaN, the electron supply layer 22 is formed of n-AlGaN, and the cap layer 23 is formed of n-GaN. With this structure, 2DEG 21a is generated in the neighborhood of the interface between the electron supply layer 22 and the electron transit layer 21 in the electron transit layer 21. Also, a spacer layer made of i-AlGaN may be formed between the electron transit layer 21 and the electron supply layer 22 (not illustrated).

Next, as illustrated in FIG. 13B, a source electrode 42 and a drain electrode 43 are formed on the electron supply layer 22. Specifically, by applying photoresist on the surface of the cap layer 23, which is then exposed by an exposure device and developed, a photoresist pattern (not illustrated) is formed that has openings in regions where the source electrode 42 and the drain electrode 43 are to be formed. After that, the cap layer 23 is removed in the regions where the photoresist pattern is not formed, by dry etching such as RIE that uses a chlorine-based gas as an etching gas. At this moment, a part of the electron supply layer 22 may be removed. After that, a stacked metal film made of Ti/Al is formed on the surface where the photoresist pattern is formed by vacuum deposition, and then, by dipping into an organic solvent or the like, the stacked metal film formed on the photoresist pattern is removed by liftoff, along with the photoresist pattern. Thus, the source electrode 42 and the drain electrode 43 are formed with the remaining stacked metal film on the electron supply layer 22. After that, heat treatment is applied in a nitrogen atmosphere at a temperature of 400 °C to 1000 °C to make the source electrode 42 and the drain electrode 43 have ohmic contacts.

Next, as illustrated in FIG. 13C, carbonization is performed by applying heat at a temperature of 400 °C to 1000 °C in a hydrocarbon gas or a carbonic acid gas atmosphere in a chamber of a plasma CVD device. After that, the insulation film 30 is formed on the cap layer 23 that has an opening 30a at the region where a gate electrode 41 is to be formed. In the present embodiment, a mixed gas of carbon dioxide and nitrogen is introduced into the chamber of the plasma CVD device for forming the insulation film 30, and heat is applied in the atmosphere to have n-GaN on the surface of the cap layer 23 attached with C. At this moment, the heating temperature is at 400 °C to 1000 °C. Carbonization may also be performed in an atmosphere that includes one of carbon dioxide, carbon monoxide, methane, ethane, and ethylene. This process forms bonds between Ga and C in the neighborhood of the surface of the cap layer 23, which reduces dangling bonds of Ga in the neighborhood of the surface of the cap layer 23.

Next, following the heat application, the insulation film 30 is formed of SiN having the thickness of 10 nm to 100 nm on the cap layer 23 by plasma CVD in the chamber of the plasma CVD device. This bonds Si and C that are included in the insulation film 30 in the neighborhood of the interface between the cap layer 23 and the insulation film 30. Note that the insulation film 30 is formed to have the thickness of about 40 nm in the present embodiment. After that, by applying photoresist on the formed insulation film 30, which is then exposed by an exposure device and developed, a photoresist pattern (not illustrated) is formed that has an opening in a region where the opening 30a is to be formed. After that, by dry etching such as RIE that uses a fluorine-based gas as an etching gas, the insulation film 30 is removed in the region where the photoresist pattern is not formed so that the cap layer 23 is exposed, and the opening 30a is formed in the insulation film 30. After that, the photoresist pattern (not illustrated) is removed by an organic solvent or the like.

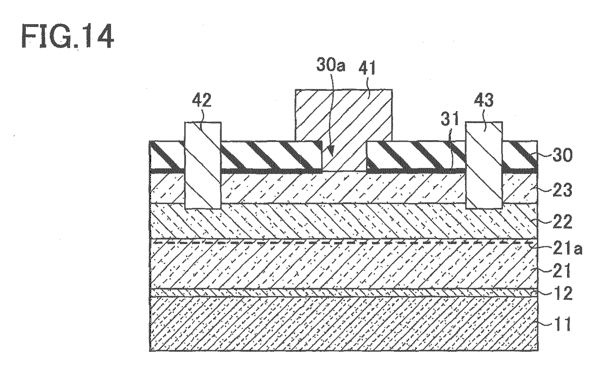

Next, as illustrated in FIG. 14, the gate electrode 41 is formed in a predetermined region at the opening 30a on the cap layer 23 and on the insulation film 30 in the neighborhood of the opening 30a. Specifically, by applying photoresist on the insulation film 30 and the cap layer 23 exposed at the opening 30a, which is then exposed by an exposure device and developed, a photoresist pattern (not illustrated) is formed that has openings in the region where the gate electrode 41 is to be formed. After that, a stacked metal film made of Ni/Au is formed on the surface where the photoresist pattern is formed by vacuum deposition, and then, by dipping into an organic solvent or the like, the stacked metal film formed on the photoresist pattern is removed by liftoff, along with the photoresist pattern. Thus, the gate electrode 41 is formed with the remaining stacked metal film at the opening 30a on the cap layer 23 and on the insulation film 30 in the neighborhood of the opening 30a.

Thus, the semiconductor device can be manufactured according to the present embodiment. Note that the content other than described above is substantially the same as in the first embodiment.

### [Fourth Embodiment]

### (Semiconductor device)

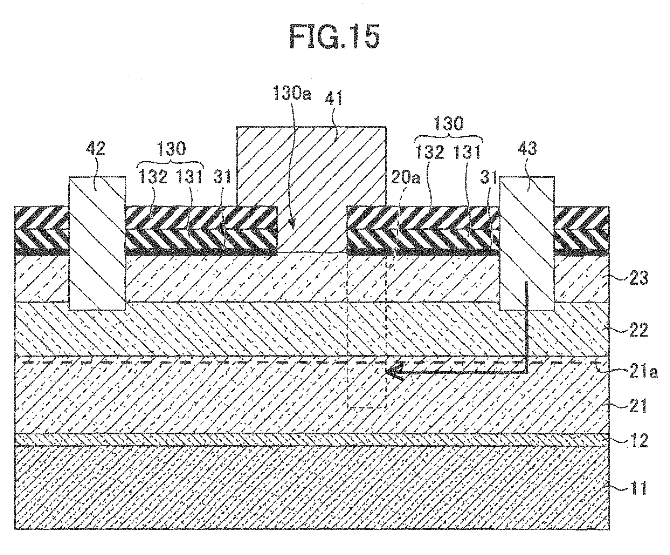

Next, a fourth embodiment will be described. The present embodiment relates to a semiconductor device that has a structure where an insulation film is formed with a multi-layer film. The semiconductor device will be described according to the present embodiment based on FIG. 15. The semiconductor device in the present embodiment has layers formed on a substrate 11 made of SiC, Si or the like that includes a buffer layer 12, an electron transit layer 21, an electron supply layer 22, and a cap layer 23, which are stacked in this order and formed by epitaxial growth.

The buffer layer 12 includes a nucleation layer, and is formed of AlN, AlGaN, or the like. The electron transit layer 21 is formed of i-GaN, the electron supply layer 22 is formed of AlGaN, and the cap layer 23 is formed of GaN. With this structure, 2DEG 21a is generated in the neighborhood of the interface between the electron supply layer 22 and the electron transit layer 21 in the electron transit layer 21. An insulation film 130 is formed by stacking a first insulation film 131 and a second insulation film 132 on the cap layer 23, and an opening 130a is formed in the first insulation film 131 and the second insulation film 132. A gate electrode 41 is formed at the opening 130a on the cap layer 23 and on the second insulation film 132 in the neighborhood of the opening 130a. Also, a source electrode 42 and a drain electrode 43 are formed on the electron supply layer 22 that is exposed by removing the cap layer 23. Note that the first insulation film 131 is formed of SiCO, and the second insulation film 132 is formed of SiN in the present embodiment.

In the semiconductor device according to the present embodiment, carbon (C) 31 is included in the cap layer 23 and the first insulation film 131 in the neighborhood of the interface between the cap layer 23 and the first insulation film 131. This makes Ga in the cap layer 23 and Si in the first insulation film 131 be bonded with C, which makes the number of dangling bonds of Ga in the cap layer 23 and dangling bonds of Si in the first insulation film 131 extremely small. By reducing the dangling bonds in this way, traps of holes or electrons in the neighborhood of the interface between the cap layer 23 and the first insulation film 131 can be reduced or eliminated. With such reduced or eliminated traps, if a voltage is applied to the gate electrode 41 to turn it off, a depletion layer extends enough to a region where the 2DEG 21a is generated, which reduces the gate leakage current via the 2DEG 921a.

Note that although the semiconductor device in FIG. 15 is described with the structure in which the cap layer 23 is formed, it is substantially the same as a semiconductor device having a structure in which the first insulation film 131 and the second insulation film 132 are formed on the electron supply layer 22 without forming the cap layer 23.

Also, although the above first insulation film 131 is made of SiCO , the first insulation film 131 may be made of SiC. Also, although the above second insulation film 132 is made of SiN, the second insulation film 132 may use a material including one of SiO₂, SiC, SiON, SiCN, SiCO, AlN, Al₂O₃, and AlON. Also, the second insulation film 132 may be a multi-layer film that is made of two or more materials selected among SiN, SiO₂, SiC, SiON, SiCN, SiCO, AlN, Al₂O₃, and AlON.

Also note that although the above case is described where the electron supply layer 22 is made of AlG, the electron supply layer 22 may be formed of a material including InAlN and InGaAlN.

### (Manufacturing method of semiconductor device)

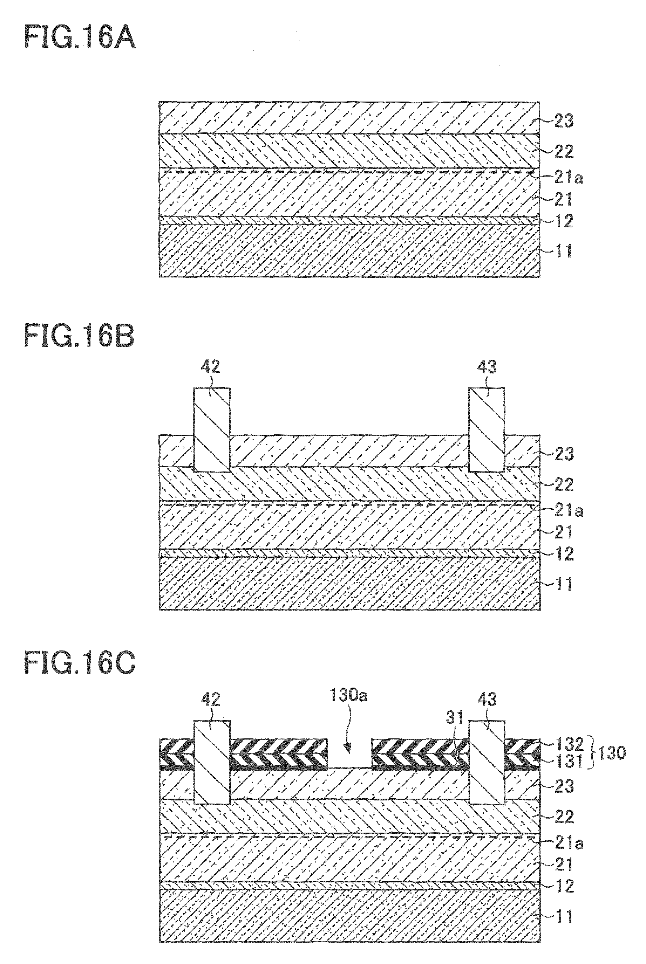

Next, a manufacturing method of a semiconductor device in the present embodiment will be described based on FIGs. 16A-17.

First, as illustrated in FIG. 16A, layers are formed on a substrate 11 of SiC or the like that include a buffer layer 12, an electron transit layer 21, an electron supply layer 22, and a cap layer 23 in order, by epitaxial growth using MOVPE. Note that the electron transit layer 21 is formed of i-GaN, the electron supply layer 22 is formed of n-AlGaN, and the cap layer 23 is formed of n-GaN. With this structure, 2DEG 21a is generated in the neighborhood of the interface between the electron supply layer 22 and the electron transit layer 21 in the electron transit layer 21. Also, a spacer layer made of i-AlGaN may be formed between the electron transit layer 21 and the electron supply layer 22 (not illustrated).

Next, as illustrated in FIG. 16B, a source electrode 42 and a drain electrode 43 are formed on the electron supply layer 22. Specifically, by applying photoresist on the surface of the cap layer 23, which is then exposed by an exposure device and developed, a photoresist pattern (not illustrated) is formed that has openings in regions where the source electrode 42 and the drain electrode 43 are to be formed. After that, the cap layer 23 is removed in the regions where the photoresist pattern is not formed, by dry etching such as RIE that uses a chlorine-based gas as an etching gas. At this moment, a part of the electron supply layer 22 may be removed. After that, a stacked metal film made of Ti/Al is formed on the surface where the photoresist pattern is formed by vacuum deposition, and then, by dipping into an organic solvent or the like, the stacked metal film formed on the photoresist pattern is removed by liftoff, along with the photoresist pattern. Thus, the source electrode 42 and the drain electrode 43 are formed with the remaining stacked metal film.

Next, as illustrated in FIG. 16C, the first insulation film 131 and the second insulation film 132 are formed on the cap layer 23, and an opening 130a is formed in the first insulation film 131 and the second insulation film 132. Specifically, the first insulation film 131 is formed by forming a film of SiCO that has the thickness of 10 nm to 100 nm on the cap layer 23, by using plasma CVD (Chemical Vapor Deposition). When forming the first insulation film 131 of SiCO, heat is applied at a temperature greater than or equal to 400 °C, and a gas including a carbon component such as carbonic acid gas is supplied, with which carbonization is applied to Ga and Si in the neighborhood of the interface between the cap layer 23 and the first insulation film 131. In this way, carbon (C) 31 can be included in the cap layer 23 and the first insulation film 131 in the neighborhood of the interface between the cap layer 23 and the first insulation film 131. Thus, dangling bonds of Ga can be reduced in the neighborhood of the interface between the cap layer 23 and the first insulation film 131, by having Ga and Si be bonded with C in the neighborhood of the interface between the cap layer 23 and the first insulation film 131 to include C. Note that the first insulation film 131 is formed to have the thickness of about 10 nm in the present embodiment. Next, the second insulation film 132 of SiN having the thickness of 10 nm to 100 nm on the first insulation film 131 by plasma CVD. Note that the second insulation film 132 is formed to have the thickness of about 40 nm in the present embodiment.

After that, by applying photoresist on the formed second insulation film 132, which is then exposed by an exposure device and developed, a photoresist pattern (not illustrated) is formed that has an opening in the region where the opening 130a is to be formed. After that, the first insulation film 131 and the second insulation film 132 are removed in the region where the photoresist pattern is not formed, by dry etching such as RIE that uses a fluorine-based gas as an etching gas. After that, the photoresist pattern (not illustrated) is removed by an organic solvent or the like.

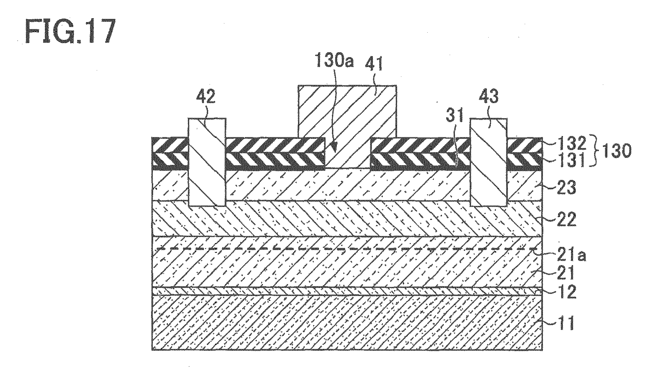

Next, as illustrated in FIG. 17, the gate electrode 41 is formed in a predetermined region at the opening 130a on the cap layer 23 and the neighborhood of the opening 130a on the second insulation film 132. Specifically, by applying photoresist on the second insulation film 132 and the cap layer 23 exposed at the opening 130a, which is then exposed by an exposure device and developed, a photoresist pattern (not illustrated) is formed that has openings in the region where the gate electrode 41 is to be formed. After that, a stacked metal film made of Ni/Au is formed on the surface where the photoresist pattern is formed by vacuum deposition, and then, by dipping into an organic solvent or the like, the stacked metal film formed on the photoresist pattern is removed by liftoff, along with the photoresist pattern. Thus, the gate electrode 41 is formed with the remaining stacked metal film at the opening 130a on the cap layer 23 and on the second insulation film 132 in the neighborhood of the opening 130a.

Thus, the semiconductor device can be manufactured according to the present embodiment. Note that the content other than described above is substantially the same as in the first embodiment.

### [Fifth embodiment]

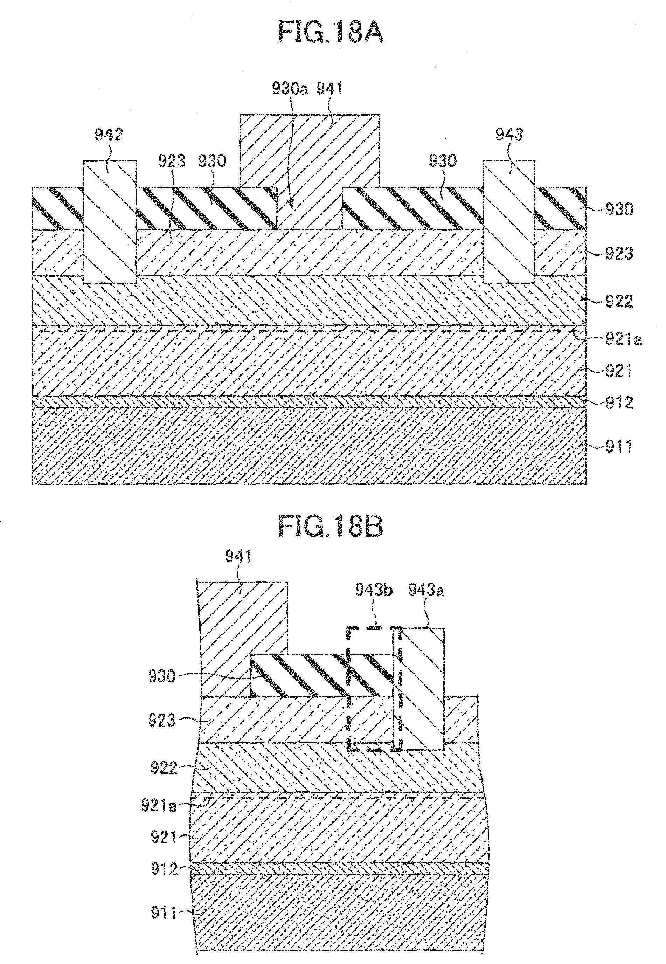

Incidentally, improvement of power added efficiency (PAE) is required in a conventional semiconductor device illustrated in FIG. 18A. As a method to improve the power added efficiency of such a semiconductor device, there is a method that shortens the distance between a gate electrode 941 and a drain electrode 943. Specifically, as illustrated in FIG. 18B, the method forms a drain electrode 943b, which is designated with a dashed line, at a position closer to the gate electrode 941 than a usual position of a drain electrode 943a in the semiconductor device. In the following, for convenience's sake, a semiconductor device having the drain electrode 943a formed at the usual position is designated with 18A, and a semiconductor device having the drain electrode 943b formed at a position closer to the gate electrode 941 than the usual position of the drain electrode 943a is designated with 18B.

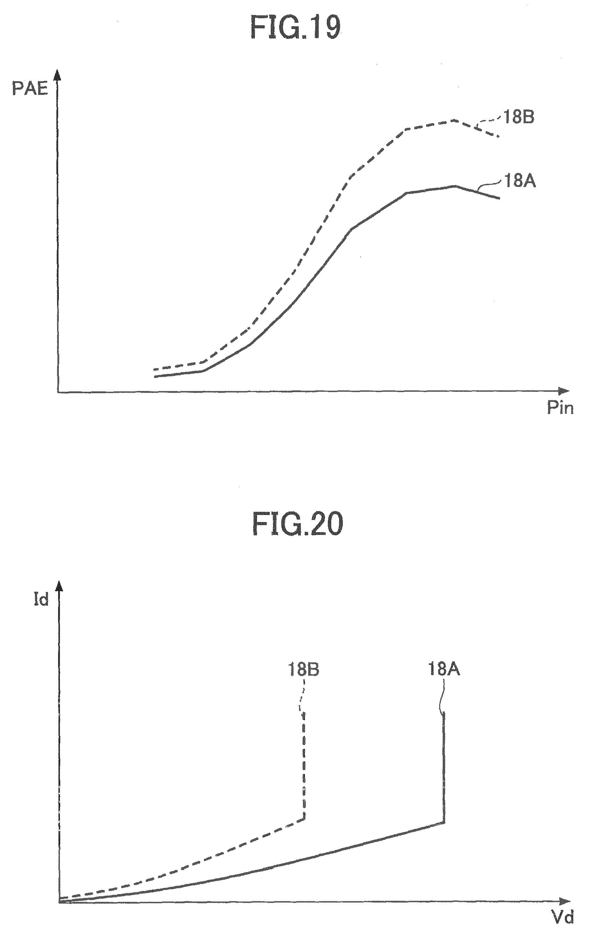

FIG. 19 illustrates a relationship between power input (Pin) to the semiconductor devices and the power added efficiency (PAE) of the semiconductor devices. As illustrated in FIG. 19, the semiconductor device 18B having the drain electrode 943b formed at the position closer to the gate electrode 941 than the usual position of the drain electrode 943a can be made to have higher power added efficiency than the semiconductor device 18A having the drain electrode 943a formed at the usual position.

FIG. 20 illustrates a relationship between the drain voltage Vd and the drain current Id of the semiconductor devices. As illustrated in FIG. 20, the semiconductor device 18B having the drain electrode 943b formed at the position closer to the gate electrode 941 than the usual position of the drain electrode 943a has a lower pinch-off voltage than the semiconductor device 18A having the drain electrode 943a formed at the usual position.

As above, if the drain electrode 943 is positioned closer to the gate electrode 941, the power added efficiency can be raised, but the voltage resistance is lowered. Namely, the power added efficiency and the voltage resistance have a trade-off relationship. Therefore, a semiconductor device has been desired that operates with raised power added efficiency without lowering the voltage resistance.

### (Semiconductor device)

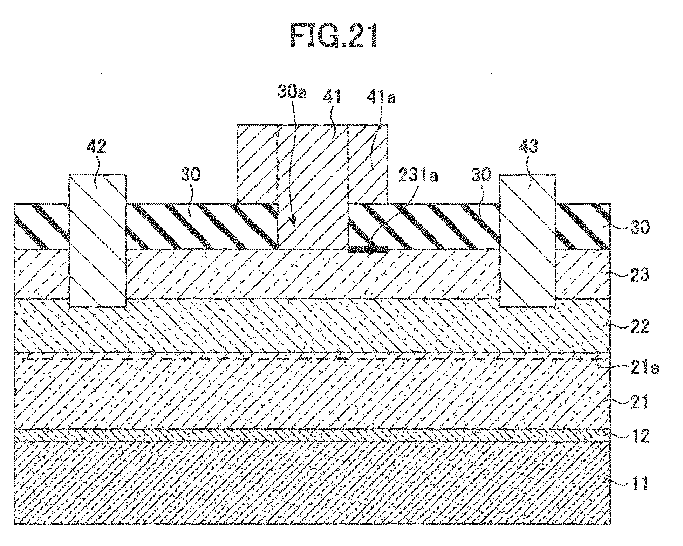

Next, a semiconductor device will be described according to a fifth embodiment based on FIG. 21. The semiconductor device in the present embodiment has a structure in which a region including carbon is formed immediately below a gate electrode field plate 41a on the side of the drain electrode 43 of the gate electrode 41 at the interface and its neighborhood between the cap layer 23 and the insulation film 30.

The semiconductor device in the present embodiment has layers formed on a substrate 11 made of SiC, Si or the like that includes a buffer layer 12, an electron transit layer 21, an electron supply layer 22, and a cap layer 23, which are stacked in this order and formed by epitaxial growth. Note that there are cases in the present embodiment where the electron transit layer 21 is referred to as a first semiconductor layer, the electron supply layer 22 is referred to as a second semiconductor layer, and the cap layer 23 is referred to as a third semiconductor layer. Also note that there are cases where a nitride semiconductor refers to a nitride semiconductor layer that includes stacked layers of an electron transit layer 21 and an electron supply layer 22, or stacked layers of an electron transit layer 21, an electron supply layer 22 and a cap layer 23.

The buffer layer 12 includes a nucleation layer, and is formed of AlN, AlGaN, or the like. The electron transit layer 21 is formed of i-GaN, the electron supply layer 22 is formed of AlGaN, and the cap layer 23 is formed of GaN. With this structure, 2DEG 21a is generated in the neighborhood of the interface between the electron supply layer 22 and the electron transit layer 21 in the electron transit layer 21. An insulation film 30 having an opening 30a is provided on the cap layer 23, and a gate electrode 41 is formed at the opening 30a on the cap layer 23 and on the insulation film 30 in the neighborhood of the opening 30a. The gate electrode field plate 41a is a part of the gate electrode 41 that is formed in a region on the insulation film 30. Also, a source electrode 42 and a drain electrode 43 are formed on the electron supply layer 22 that is exposed by removing the cap layer 23. Note that the insulation film 30 is formed of SiCO, and the second insulation film 132 is formed of SiN in the present embodiment. Note that the insulation film 30 is formed of silicon oxide (SiO₂ or silicon nitride (SiN).

Incidentally, if the entire region between the cap layer 23 and the insulation film 30 is formed to include carbon, the power added efficiency is lowered due to the trap effect of carbon, although the voltage resistance is improved. Therefore, in the semiconductor device in the present embodiment, a region 231a that includes carbon is formed only immediately below the gate electrode field plate 41a on the side of the drain electrode 43 of the gate electrode 41 at the interface and its neighborhood between the cap layer 23 and the insulation film 30. By limiting the region 231a that includes carbon to a minimum necessary part of the interface between the cap layer 23 and the insulation film 30, the power added efficiency can be raised without lowering the voltage resistance.

This makes it possible to prevent the voltage resistance from being lowered even if the distance between the gate electrode 41 and the drain electrode 43 is shortened because the region 231a that includes carbon is formed immediately below the gate electrode field plate 41a on the side of the drain electrode 43 of the gate electrode 41.

Next, an effect of the semiconductor device will be described according to the present embodiment. In the following, for convenience's sake, the semiconductor device in the present embodiment is designated with 21A.

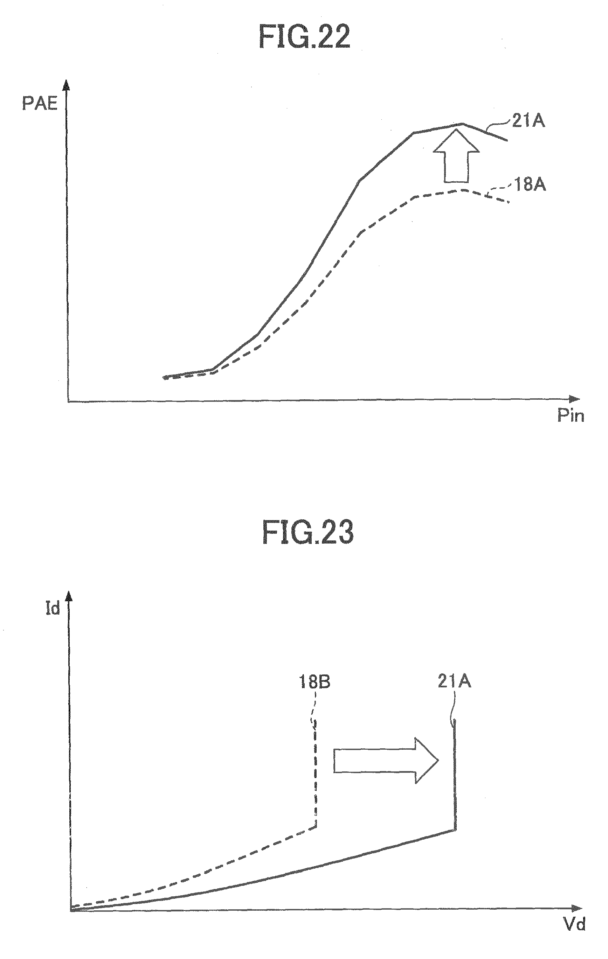

FIG. 22 illustrates a relationship between power input (Pin) to the semiconductor devices and power added efficiency (PAE). As illustrated in FIG. 22, the semiconductor device 21A can be made to have higher power added efficiency than the semiconductor device 18A having the drain electrode 943a formed at the usual position illustrated in FIG. 18B. This is because the semiconductor device 21A in the present embodiment has the drain electrode formed closer to the gate electrode than that of the semiconductor device 18A.

FIG. 23 illustrates a relationship between the drain voltage Vd and the drain current Id of the semiconductor devices. As illustrated in FIG. 23, the semiconductor device 21A has a higher pinch-off voltage than the semiconductor device 18B having the drain electrode 943b formed at the position closer to the gate electrode 941 illustrated in FIG. 18B. Specifically, although not illustrated in FIG. 23, the semiconductor device 21A has the voltage resistance that is substantially the same as that of the semiconductor device 18A having the drain electrode 943a formed at the usual position illustrated in FIG. 18B.

Therefore, the semiconductor device in the present embodiment can raise the power added efficiency without lowering the voltage resistance.

Note that although the semiconductor device in FIG. 21 is described with the structure in which the cap layer 23 is formed, it is substantially the same as a semiconductor device having a structure in which the insulation film 30 is formed on the electron supply layer 22 without forming the cap layer 23. Specifically, the semiconductor device may have a structure in which the region 231a including carbon is formed immediately below the gate electrode field plate 41a on the side of the drain electrode 43 in the neighborhood of the interface between the electron supply layer 22 and the insulation film 30.

### (Manufacturing method of semiconductor device)

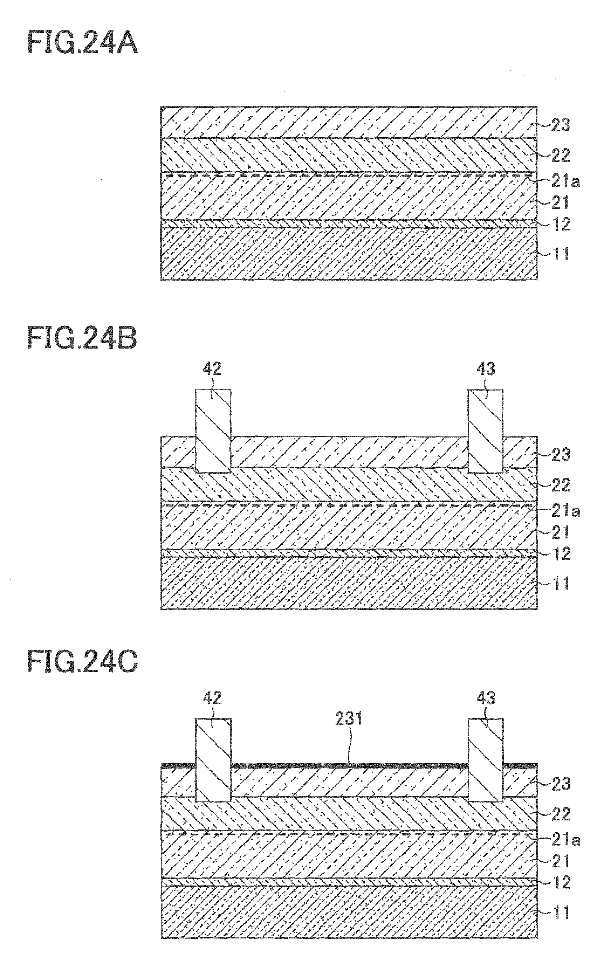

Next, a manufacturing method of the semiconductor device in the present embodiment will be described based on FIGs. 24A-26C.

First, as illustrated in FIG. 24A, layers are formed on a substrate 11 that include a buffer layer 12, an electron transit layer 21, an electron supply layer 22, and a cap layer 23 in order, by epitaxial growth using MOVPE. Note that the substrate 11 is formed of SiC or the like, the electron transit layer 21 is formed of i-GaN, the electron supply layer 22 is formed of n-AlGaN, and the cap layer 23 is formed of n-GaN. With this structure, 2DEG 21a is generated in the neighborhood of the interface between the electron supply layer 22 and the electron transit layer 21 in the electron transit layer 21. Also, a spacer layer made of i-AlGaN may be formed between the electron transit layer 21 and the electron supply layer 22 (not illustrated).

Next, as illustrated in FIG. 24B, a source electrode 42 and a drain electrode 43 are formed on the electron supply layer 22. Specifically, by applying photoresist on the surface of the cap layer 23, which is then exposed by an exposure device and developed, a photoresist pattern (not illustrated) is formed that has openings in regions where the source electrode 42 and the drain electrode 43 are to be formed. After that, the cap layer 23 is removed in the regions where the photoresist pattern is not formed, by dry etching such as RIE that uses a chlorine-based gas as an etching gas. At this moment, a part of the electron supply layer 22 may be removed. After that, a stacked metal film made of Ti/Al is formed on the surface where the photoresist pattern is formed by vacuum deposition, and then, by dipping into an organic solvent or the like, the stacked metal film formed on the photoresist pattern is removed by liftoff, along with the photoresist pattern. Thus, the source electrode 42 and the drain electrode 43 are formed with the remaining stacked metal film.

Next, as illustrated in FIG. 24C, heat treatment is applied in a hydrocarbon gas or a carbonic acid gas atmosphere at a temperature of 400 °C to 1000 °C. The heat treatment makes the source electrode 42 and the drain electrode 43 have ohmic contacts, and carbonizes the surface of the cap layer 23 to attach C with n-GaN. Thus, a layer 231 that includes carbon is formed on the surface of the cap layer 23. In the present embodiment, carbonization is performed in a mixed gas atmosphere of carbon dioxide and nitrogen. Note that there are cases in the present embodiment where carbonization refers to heat treatment in a hydrocarbon gas or a carbonic acid gas atmosphere at a temperature of 400 °C to 1000 °C. Also, carbonization may be performed in an atmosphere including one of carbon dioxide, carbon monoxide, methane, ethane, and ethylene. With the carbonization, Ga and C can be bonded in the neighborhood of the surface of the cap layer 23, which reduces dangling bonds of Ga in the neighborhood of the surface of the cap layer 23.

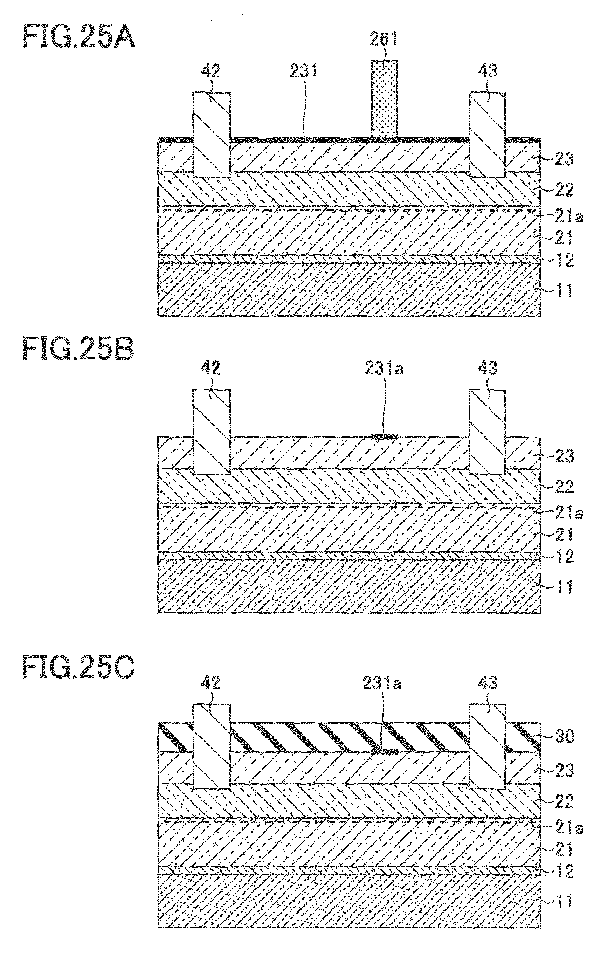

Next, as illustrated in FIG. 25A, a photoresist pattern 261 is formed in a region where a region 231a including carbon is to be formed on the layer 231 that includes carbon. Specifically, by applying photoresist on the layer 231 that includes carbon, which is then exposed by an exposure device and developed, the photoresist pattern 261 is formed on the region where the region 231a including carbon is to be formed.

Next, as illustrated in FIG. 25B, the layer 231 that includes carbon is removed in the region where the photoresist pattern is not formed, by dry etching such as RIE that uses a chlorine-based gas as an etching gas. Thus, the region 231a including carbon is formed with the remaining layer 231 that includes carbon below the photoresist pattern 261. After that, the photoresist pattern 261 is removed by an organic solvent or the like.

Next, as illustrated in FIG. 25C, the insulation film 30 is formed on the cap layer 23. Specifically, the insulation film 30 is formed by forming a film of SiN that has the thickness of 10 nm to 5000 nm on the cap layer 23, by using plasma CVD. This bonds Si and C that are included in the insulation film 30 in the neighborhood of the interface between the cap layer 23 and the insulation film 30 in the region 231a that includes carbon. Note that the insulation film 30 is formed to have the thickness of about 100 nm in the present embodiment.

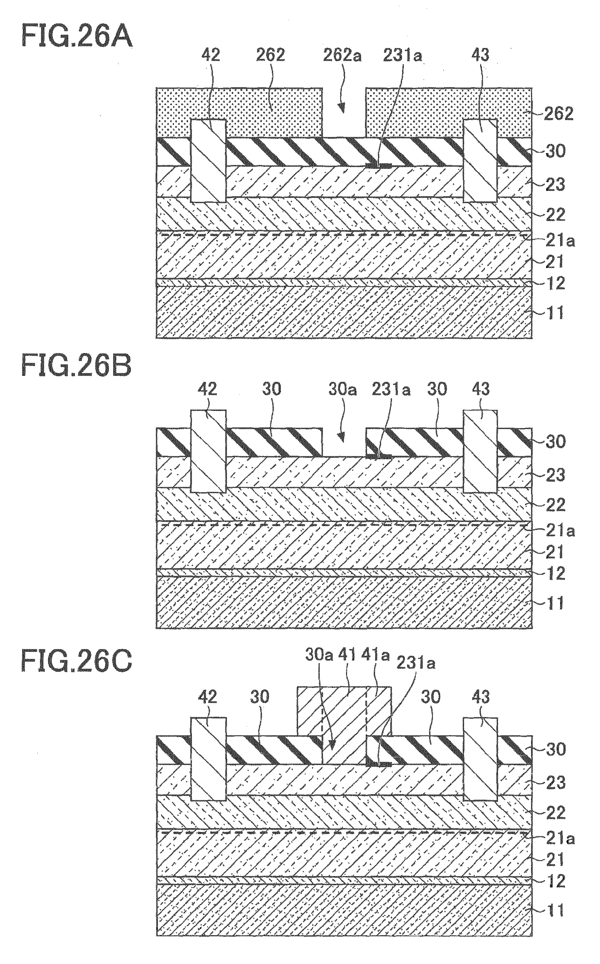

Next, as illustrated in FIG. 26A, by applying photoresist on the formed insulation film 30, which is then exposed by an exposure device and developed, a photoresist pattern 262 is formed that has an opening 262a in a region where a gate electrode 41 is to be formed. The photoresist pattern 262 is formed so that the terminal part at the side of the region 231a including carbon towards the source electrode 42 is positioned immediately below the terminal part of the photoresist pattern 262 at the opening 262a on the side of the drain electrode 43.

Next, as illustrated in FIG. 26B, by dry etching such as RIE that uses a fluorine-based gas as an etching gas, the insulation film 30 is removed in the region of the opening 262a in the photoresist pattern 262 so that the cap layer 23 is exposed, and the opening 30a is formed in the insulation film 30. After that, the photoresist pattern 262 is removed by an organic solvent or the like.

Next, as illustrated in FIG. 26C, the gate electrode 41 is formed in a predetermined region at the opening 30a on the cap layer 23 and on the insulation film 30 in the neighborhood of the opening 30a. Specifically, by applying photoresist on the insulation film 30 and the cap layer 23 exposed at the opening 30a, which is then exposed by an exposure device and developed, a photoresist pattern (not illustrated) is formed that has an opening in the region where the gate electrode 41 is to be formed. The opening of the photoresist pattern (not illustrated) is formed to be greater than the opening 30a in the insulation film 30. After that, a stacked metal film made of Ni/Au is formed on the surface where the photoresist pattern is formed by vacuum deposition, and then, by dipping into an organic solvent or the like, the stacked metal film formed on the photoresist pattern is removed by liftoff, along with the photoresist pattern. Thus, the gate electrode 41 is formed with the remaining stacked metal film at the opening 30a on the cap layer 23 and on the insulation film 30 in the neighborhood of the opening 30a. In the formed gate electrode 41, the region formed on the insulation film 30 is the gate electrode field plate 41a, and the region 231a including carbon is formed positioned immediately below the gate electrode field plate 41a.

Thus, the semiconductor device can be manufactured according to the present embodiment.

### [Sixth embodiment]

### (Semiconductor device)

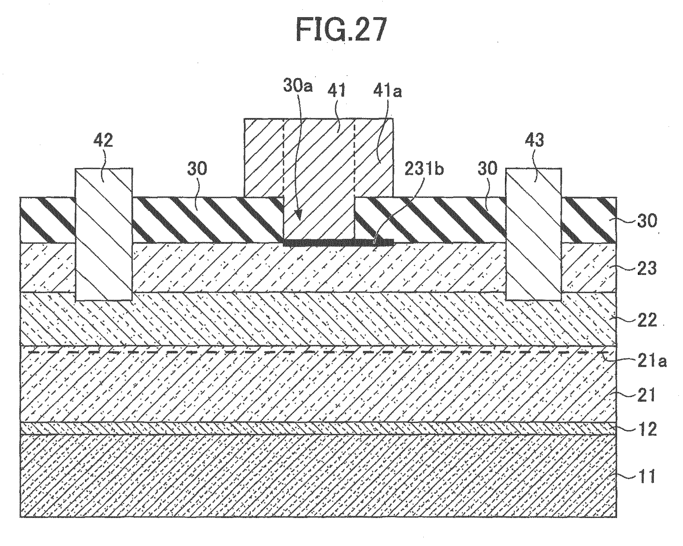

Next, a semiconductor device will be described according to a sixth embodiment based on FIG. 27. The semiconductor device in the present embodiment has a structure in which a region including carbon is formed immediately below a gate electrode, and immediately below a gate electrode field plate 41a at the side of the gate electrode 41 towards a drain electrode 43, at the interface and its neighborhood between a cap layer 23 and an insulation film 30.

The semiconductor device in the present embodiment has layers formed on a substrate 11 made of SiC, Si or the like that includes a buffer layer 12, an electron transit layer 21, an electron supply layer 22, and the cap layer 23, which are stacked in this order and formed by epitaxial growth. Note that there are cases where the electron transit layer 21 is referred to as a first semiconductor layer, the electron supply layer 22 is referred to as a second semiconductor layer, and the cap layer 23 is referred to as a third semiconductor layer in the present embodiment. Also note that there are cases where a nitride semiconductor refers to a nitride semiconductor layer that includes stacked layers of the electron transit layer 21 and the electron supply layer 22, or stacked layers of the electron transit layer 21, the electron supply layer 22 and the cap layer 23.

The buffer layer 12 includes a nucleation layer, and is formed of AlN, AlGaN, or the like. The electron transit layer 21 is formed of i-GaN, the electron supply layer 22 is formed of AlGaN, and the cap layer 23 is formed of GaN. With this structure, 2DEG 21a is generated in the neighborhood of the interface between the electron supply layer 22 and the electron transit layer 21 in the electron transit layer 21. An insulation film 30 having an opening 30a is provided on the cap layer 23, and the gate electrode 41 is formed at the opening 30a on the cap layer 23 and on the insulation film 30 in the neighborhood of the opening 30a. The gate electrode field plate 41a is a part of the gate electrode 41 that is formed in a region on the insulation film 30. Also, a source electrode 42 and a drain electrode 43 are formed on the electron supply layer 22 that is exposed by removing the cap layer 23. Note that the insulation film 30 is formed of silicon oxide (SiO₂ or silicon nitride (SiN).

In the present embodiment, a region 231b including carbon is formed immediately below the gate electrode field plate 41a on the side of the gate electrode 41 towards the drain electrode 43, at the interface and its neighborhood between the cap layer 23 and the insulation film 30. By forming the region 231b including carbon immediately below the gate electrode 41 in this way, the voltage resistance can be improved.

Next, an effect of the semiconductor device will be described according to the present embodiment. In the following, for convenience's sake, the semiconductor device in the present embodiment is designated with 27A.

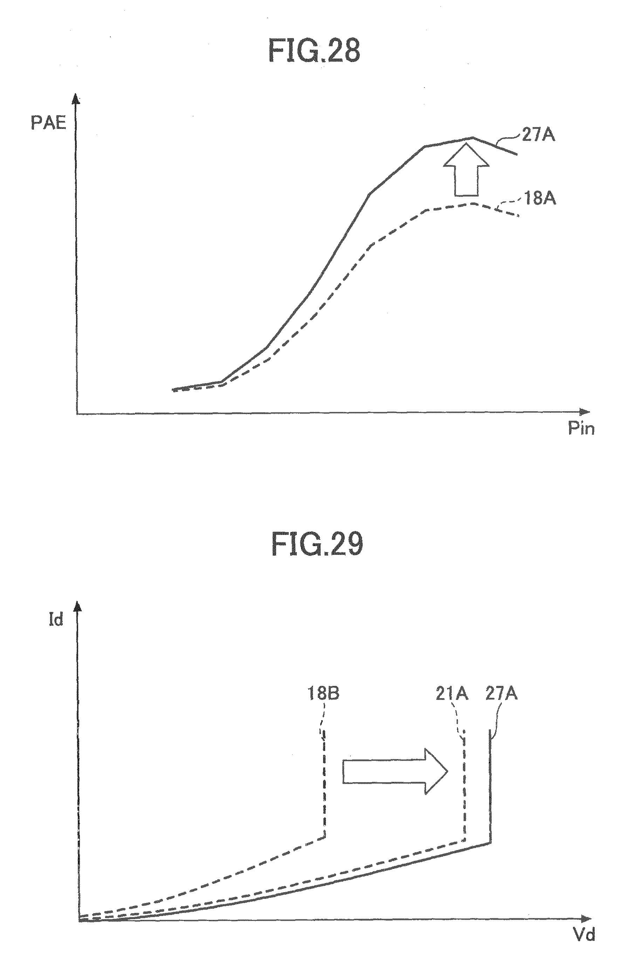

FIG. 28 illustrates a relationship between power input (Pin) to the semiconductor devices 27A and 18A and power added efficiency (PAE). As illustrated in FIG. 28, the semiconductor device 27A can be made to have higher power added efficiency than the semiconductor device 18A having the drain electrode 943a formed at the usual position illustrated in FIG. 18B, similarly to the semiconductor device according to the fifth embodiment. This is because the semiconductor device 27A in the present embodiment has the drain electrode 43 formed closer to the gate electrode 41 than that of the semiconductor device 18A, similarly to the semiconductor device according to the fifth embodiment.

FIG. 29 illustrates a relationship between the drain voltage Vd and the drain current Id of the semiconductor devices 18B, 21A, and 27A. As illustrated in FIG. 29, the semiconductor device 27A in the present embodiment has a higher voltage resistance than that of the semiconductor device 21A in the fifth embodiment. By additionally forming the region 231b including carbon immediately below the gate electrode 41, the voltage resistance can be improved. Therefore, the voltage resistance of the semiconductor device 27A in the present embodiment is further improved compared to that of the semiconductor device 21A in the fifth embodiment.

Note that although the semiconductor device in FIG. 27 is described with the structure in which the cap layer 23 is formed, it is substantially the same as a semiconductor device having a structure in which the insulation film 30 is formed on the electron supply layer 22 without forming the cap layer 23. Specifically, the semiconductor device may have a structure in which the region 231b including carbon is formed immediately below the gate electrode 41, and immediately below the gate electrode field plate 41a at the side towards the drain electrode 43 in the neighborhood of the interface between the electron supply layer 22 and the insulation film 30.

### (Manufacturing method of semiconductor device)

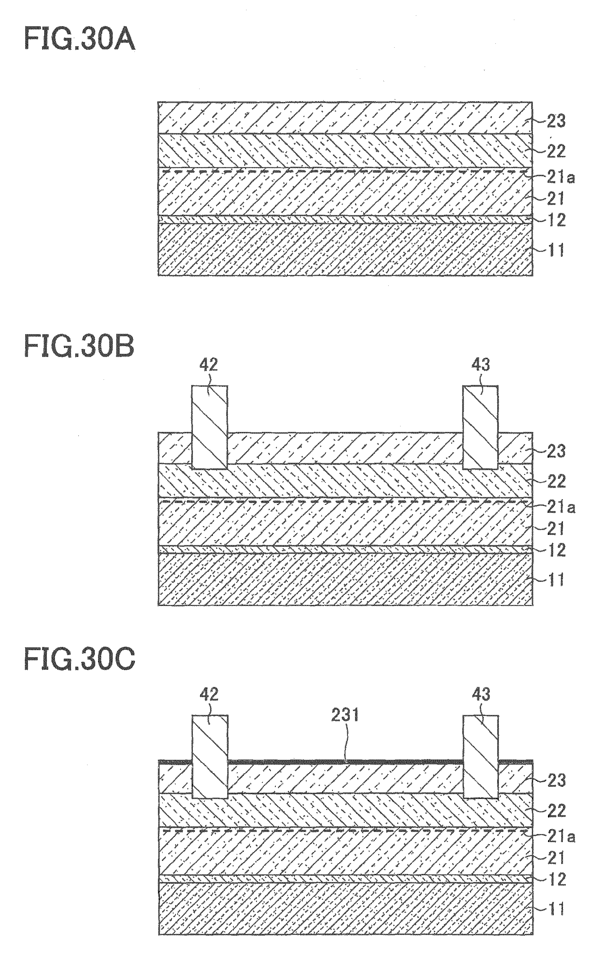

Next, a manufacturing method of the semiconductor device in the present embodiment will be described based on FIGs. 30A-32C.

First, as illustrated in FIG. 30A, layers are formed on a substrate 11 that include a buffer layer 12, an electron transit layer 21, an electron supply layer 22, and a cap layer 23 in order, by epitaxial growth using MOVPE. With this structure, 2DEG 21a is generated in the neighborhood of the interface between the electron supply layer 22 and the electron transit layer 21 in the electron transit layer 21.

Next, as illustrated in FIG. 30B, a source electrode 42 and a drain electrode 43 are formed on the electron supply layer 22. Specifically, by applying photoresist on the surface of the cap layer 23, which is then exposed by an exposure device and developed, a photoresist pattern (not illustrated) is formed that has openings in regions where the source electrode 42 and the drain electrode 43 are to be formed. After that, the cap layer 23 is removed in the regions where the photoresist pattern is not formed, by dry etching such as RIE that uses a chlorine-based gas as an etching gas. At this moment, a part of the electron supply layer 22 may be removed. After that, a stacked metal film made of Ti/Al is formed on the surface where the photoresist pattern is formed by vacuum deposition, and then, by dipping into an organic solvent or the like, the stacked metal film formed on the photoresist pattern is removed by liftoff, along with the photoresist pattern. Thus, the source electrode 42 and the drain electrode 43 are formed with the remaining stacked metal film.

Next, as illustrated in FIG. 30C, heat treatment is applied in a hydrocarbon gas or a carbonic acid gas atmosphere at a temperature of 400 °C to 1000 °C. The heat treatment makes the source electrode 42 and the drain electrode 43 have ohmic contacts, and carbonizes the surface of the cap layer 23 to attach C with n-GaN. Thus, a layer 231 that includes carbon is formed on the surface of the cap layer 23.

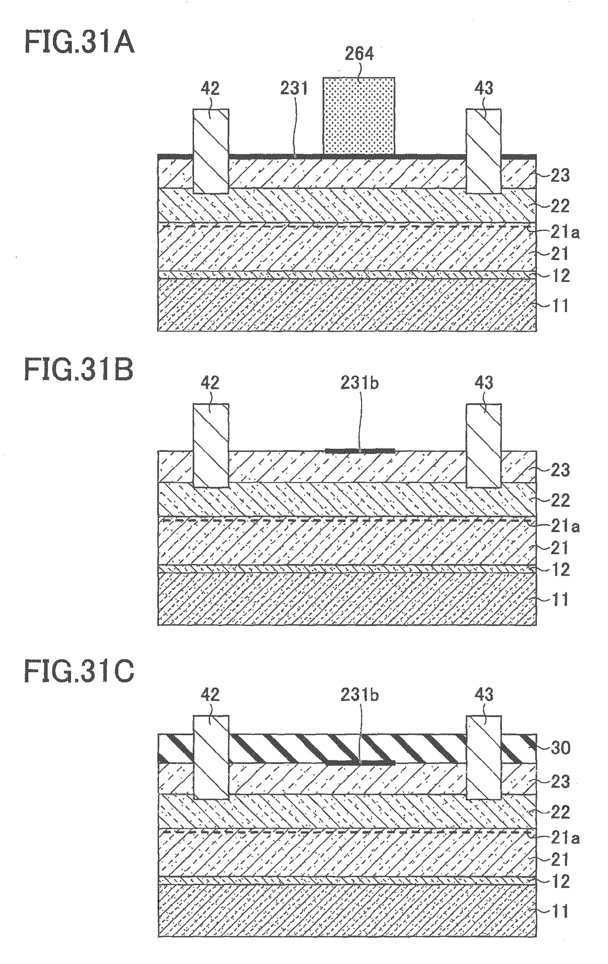

Next, as illustrated in FIG. 31A, a photoresist pattern 264 is formed in a region where a region 231b including carbon is to be formed on the layer 231 that includes carbon. Specifically, by applying photoresist on the layer 231 that includes carbon, which is then exposed by an exposure device and developed, the photoresist pattern 264 is formed on the region where the region 231b including carbon is to be formed.

Next, as illustrated in FIG. 31B, the layer 231 that includes carbon is removed in the region where the photoresist pattern 264 is not formed, by dry etching such as RIE. Thus, the region 231b including carbon is formed with the remaining layer 231 that includes carbon below the photoresist pattern 264. After that, the photoresist pattern 264 is removed by an organic solvent or the like.

Next, as illustrated in FIG. 31C, an insulation film 30 is formed on the cap layer 23. Specifically, the insulation film 30 is formed by forming a film of SiN that has the thickness of 10 nm to 5000 nm on the cap layer 23, by using plasma CVD. This bonds Si and C that are included in the insulation film 30 in the neighborhood of the interface between the cap layer 23 and the insulation film 30 in the region 231b including carbon. Note that the insulation film 30 is formed to have the thickness of about 100 nm in the present embodiment.

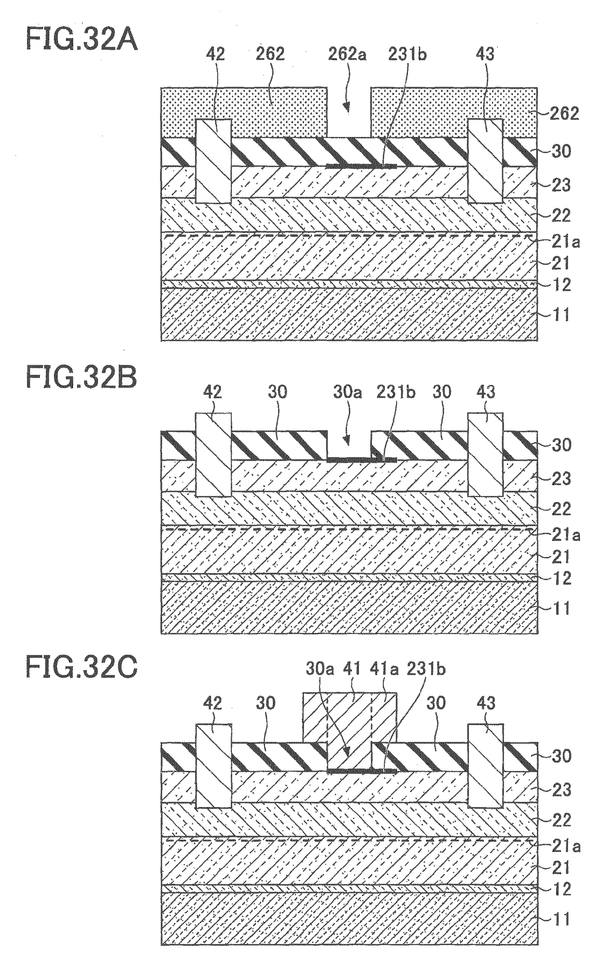

Next, as illustrated in FIG. 32A, by applying photoresist on the formed insulation film 30, which is then exposed by an exposure device and developed, a photoresist pattern 262 is formed that has an opening 262a in a region where a gate electrode 41 is to be formed. The photoresist pattern 262 is formed so that the terminal part at the side of the region 231b including carbon towards the source electrode 42 is positioned immediately below the terminal part of the photoresist pattern 262 at the opening 262a on the side of the source electrode 42. Also, the photoresist pattern 262 is formed so that the terminal part at the side of the region 231b including carbon towards the drain electrode 43 is positioned closer to the drain electrode 43 than is the terminal part of the photoresist pattern 262 at the opening 262a on the side the drain electrode 43. Therefore, the opening 262a in the photoresist pattern 262 is formed in a region smaller than the region 231b including carbon.

Next, as illustrated in FIG. 32B, by dry etching such as RIE that uses a fluorine-based gas as an etching gas, the insulation film 30 is removed in the region of the opening 262a in the photoresist pattern 262 so that the cap layer 23 is exposed, and the opening 30a is formed in the insulation film 30. After that, the photoresist pattern 262 is removed by an organic solvent or the like.

Next, as illustrated in FIG. 32C, the gate electrode 41 is formed in a predetermined region at the opening 30a on the region 231b of the cap layer 23 that includes carbon and on the insulation film 30 in the neighborhood of the opening 30a. Specifically, by applying photoresist on the insulation film 30 and the cap layer 23 exposed at the opening 30a, which is then exposed by an exposure device and developed, a photoresist pattern (not illustrated) is formed that has an opening in a region where the gate electrode 41 is to be formed. The opening of the photoresist pattern (not illustrated) is formed to be greater than the opening 30a of the insulation film 30. After that, a stacked metal film made of Ni/Au is formed on the surface where the photoresist pattern is formed by vacuum deposition, and then, by dipping into an organic solvent or the like, the stacked metal film formed on the photoresist pattern is removed by liftoff, along with the photoresist pattern. Thus, the gate electrode 41 is formed with the remaining stacked metal film at the opening 30a in the region 231b of the cap layer 23 that includes carbon, and on the insulation film 30 in the neighborhood of the opening 30a. In the formed gate electrode 41, the region formed on the insulation film 30 is the gate electrode field plate 41a, and the region 231b including carbon is formed positioned immediately below the gate electrode field plate 41a.

Thus, the semiconductor device can be manufactured according to the present embodiment. Note that the content other than described above is substantially the same as in the fifth embodiment.

### [Seventh embodiment]

Next, a seventh embodiment will be described. The present embodiment relates to a manufacturing method of a semiconductor device according to the fifth embodiment, which is different from the manufacturing method described in the fifth embodiment.

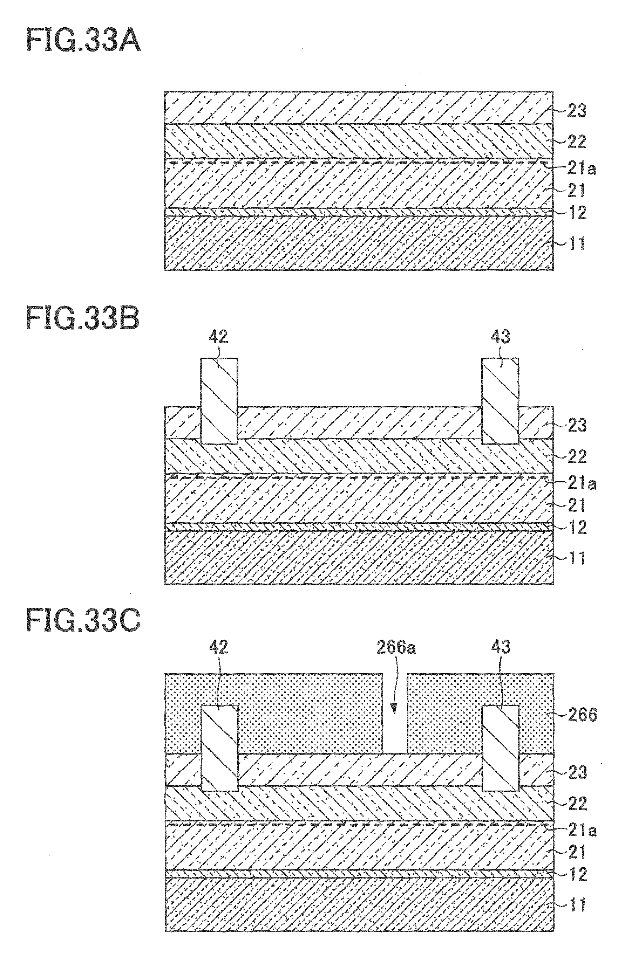

Next, the manufacturing method of a semiconductor device according to the present embodiment will be described based on FIGs. 33A-35B.

First, as illustrated in FIG. 33A, layers are formed on a substrate 11 that include a buffer layer 12, an electron transit layer 21, an electron supply layer 22, and a cap layer 23 in order, by epitaxial growth using MOVPE. With this structure, 2DEG 21a is generated in the neighborhood of the interface between the electron supply layer 22 and the electron transit layer 21 in the electron transit layer 21.

Next, as illustrated in FIG. 33B, a source electrode 42 and a drain electrode 43 are formed on the electron supply layer 22. Specifically, by applying photoresist on the surface of the cap layer 23, which is then exposed by an exposure device and developed, a photoresist pattern (not illustrated) is formed that has openings in regions where the source electrode 42 and the drain electrode 43 are to be formed. After that, the cap layer 23 is removed in the regions where the photoresist pattern is not formed, by dry etching such as RIE that uses a chlorine-based gas as an etching gas. At this moment, a part of the electron supply layer 22 may be removed. After that, a stacked metal film made of Ti/Al is formed on the surface where the photoresist pattern is formed by vacuum deposition, and then, by dipping into an organic solvent or the like, the stacked metal film formed on the photoresist pattern is removed by liftoff, along with the photoresist pattern. Thus, the source electrode 42 and the drain electrode 43 are formed with the remaining stacked metal film. After that, heat treatment is applied at a temperature of 400 °C to 1000 °C to make the source electrode 42 and the drain electrode 43 have ohmic contacts.

Next, as illustrated in FIG. 33C, a photoresist pattern 266 is formed that has an opening 266a in a region where a region 231a including carbon is to be formed on the cap layer 23. Specifically, by applying photoresist on the cap layer 23, which is then exposed by an exposure device and developed, the photoresist pattern 266 is formed on the region where the region 231a including carbon is to be formed.

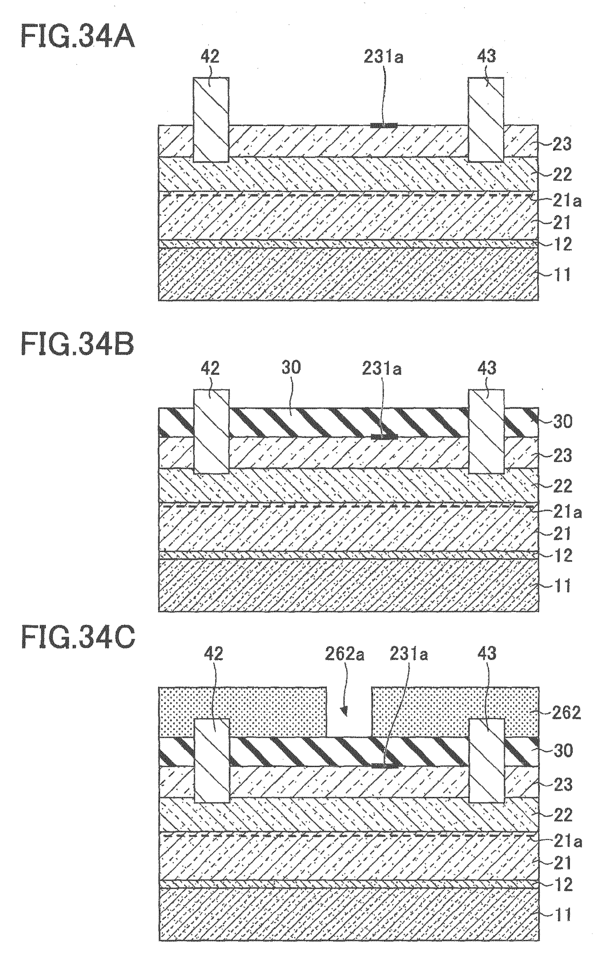

Next, as illustrated in FIG. 34A, by applying ion implantation of C (carbon) to the opening 266a of the photoresist pattern 266, the region 231a including carbon is formed at the opening 266a of the photoresist pattern 266 on the cap layer 23. After that, the photoresist pattern 266 is removed by an organic solvent or the like.

Next, as illustrated in FIG. 34B, the insulation film 30 is formed on the cap layer 23. Specifically, the insulation film 30 is formed by forming a film of SiN that has the thickness of 10 nm to 5000 nm on the cap layer 23, by using plasma CVD. This bonds Si and C that are included in the insulation film 30 in the neighborhood of the interface between the cap layer 23 and the insulation film 30 in the region 231a that includes carbon. Note that the insulation film 30 is formed to have the thickness of about 100 nm in the present embodiment.

Next, as illustrated in FIG. 34C, by applying photoresist on the formed insulation film 30, which is then exposed by an exposure device and developed, a photoresist pattern 262 is formed that has an opening 262a in a region where the gate electrode 41 is to be formed. The photoresist pattern 262 is formed so that the terminal part at the side of the region 231a including carbon towards the source electrode 42 is positioned immediately below the terminal part of the photoresist pattern 262 at the opening 262a on the side of the drain electrode 43.

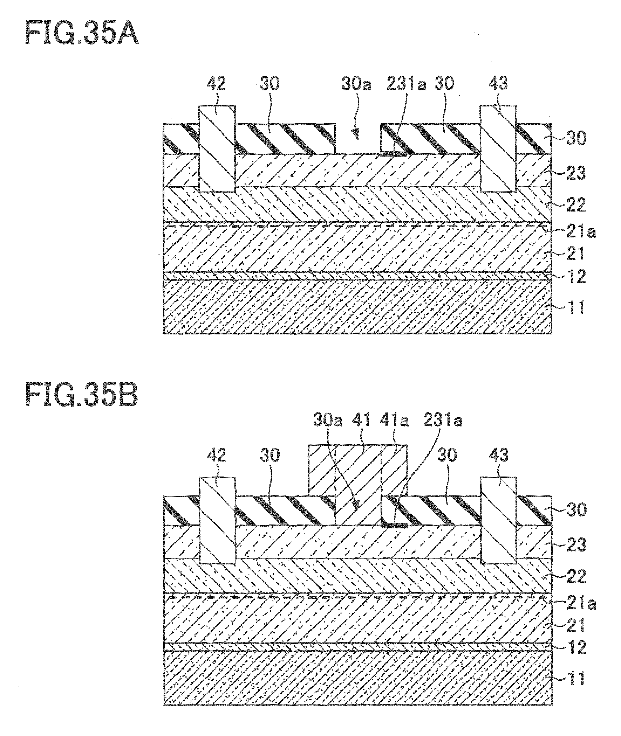

Next, as illustrated in FIG. 35A, by dry etching such as RIE that uses a fluorine-based gas as an etching gas, the insulation film 30 is removed in the region of the opening 262a in the photoresist pattern 262 so that the cap layer 23 is exposed, and the opening 30a is formed in the insulation film 30. After that, the photoresist pattern 262 is removed by an organic solvent or the like.

Next, as illustrated in FIG. 35B, the gate electrode 41 is formed in a predetermined region at the opening 30a on the cap layer 23 and on the insulation film 30 in the neighborhood of the opening 30a. Specifically, by applying photoresist on the insulation film 30 and the cap layer 23 exposed at the opening 30a, which is then exposed by an exposure device and developed, a photoresist pattern (not illustrated) is formed that has openings in the region where the gate electrode 41 is to be formed. The opening of the photoresist pattern (not illustrated) is formed to be greater than the opening 30a of the insulation film 30. After that, a stacked metal film made of Ni/Au is formed on the surface where the photoresist pattern is formed by vacuum deposition, and then, by dipping into an organic solvent or the like, the stacked metal film formed on the photoresist pattern is removed by liftoff, along with the photoresist pattern. Thus, the gate electrode 41 is formed with the remaining stacked metal film at the opening 30a on the cap layer 23 and on the insulation film 30 in the neighborhood of the opening 30a. In the formed gate electrode 41, the region formed on the insulation film 30 is the gate electrode field plate 41a, and the region 231a that includes carbon is formed to be positioned immediately below the gate electrode field plate 41a.

Thus, the semiconductor device can be manufactured according to the present embodiment. Note that the content other than described above is substantially the same as in the fifth embodiment.

### [Eighth embodiment]

Next, an eighth embodiment will be described. The present embodiment relates to a semiconductor device, a power source device, and a high-frequency amplifier.

### (Semiconductor device)

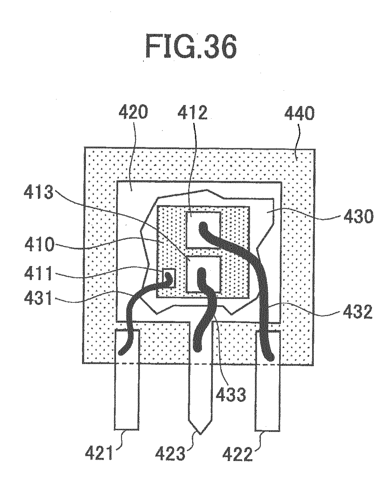

The semiconductor device in the present embodiment includes a semiconductor device according to one of the first to seventh embodiments, which is contained in a discrete package, and the discretely packaged semiconductor device will be described based on FIG. 36. Note that FIG. 36 schematically illustrates the inside of the discretely packaged semiconductor device in which positions of the electrodes and the like may be different from those in the first to seventh embodiments.

First, a semiconductor device manufactured according to one of the first to seventh embodiments is cut off by dicing or the like to form a semiconductor chip 410, which is a HEMT made of GaN semiconductor materials. The semiconductor chip 410 is fixed on a lead frame 420 by a die attachment agent 430 such as solder. Note that the semiconductor chip 410 corresponds to one of the semiconductor devices in the first to seventh embodiments.

Next, a gate electrode 411 is connected with a gate lead 421 by a bonding wire 431, a source electrode 412 is connected with a source lead 422 by a bonding wire 432, and a drain electrode 413 is connected with a drain lead 423 by a bonding wire 433. Note that the bonding wires 431, 432, and 433 are formed of a metal material such as Al. Also, the gate electrode 411 is a gate electrode pad in the present embodiment, which is connected with the gate electrode 41 of the semiconductor device according to one of the first to seventh embodiments. Also, the source electrode 412 is a source electrode pad, which is connected with the source electrode 42 of the semiconductor device according to one of the first to seventh embodiments. Also, the drain electrode 413 is a drain electrode pad, which is connected with the drain electrode 43 of the semiconductor device according to one of the first to seventh embodiments.

Next, resin sealing is performed by a transfer molding method using a mold resin 440. Thus, the HEMT made of GaN semiconductor materials can be manufactured as the discretely packaged semiconductor device.

### (PFC circuit, power source device and high frequency amplifier)

Next, a PFC circuit, a power source device and a high-frequency amplifier will be described according to the present embodiment. The PFC circuit, the power source device and the high-frequency amplifier in the present embodiment use one or more of the semiconductor devices in the first to seventh embodiments, respectively.

### (PFC circuit)

Next, the PFC (Power Factor Correction) circuit will be described according to the present embodiment. The PFC circuit in the present embodiment includes a semiconductor device according to one of the first to seventh embodiments.

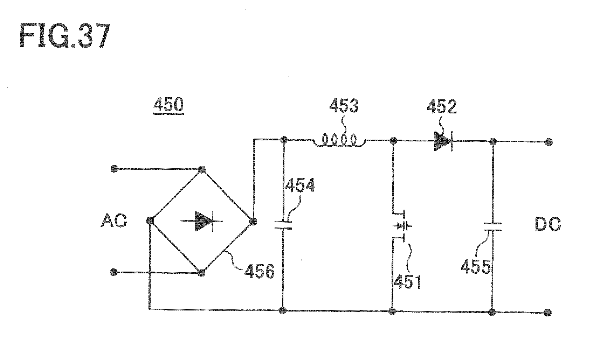

The PFC circuit 450 in the present embodiment will be described based on FIG. 37. The PFC circuit 450 in the present embodiment includes a switching element (transistor) 451, a diode 452, a choke coil 453, capacitors 454 and 455, a diode bridge 456, and an AC power supply (not illustrated). The switching element 451 includes a HEMT, or a semiconductor device according to one of the first to seventh embodiments.

The drain electrode of the switching element 451, the anode terminal of the diode 452, and one of the terminals of the choke coil 453 are connected with each other in the PFC circuit 450. Also, the source electrode of the switching element 451, one of the terminals of the capacitor 454, and one of the terminals of the capacitor 455 are connected with each other, and the other terminal of the capacitor 454 is connected with the other terminal of the choke coil 453. The other terminal of the capacitor 455 is connected with the cathode terminal of the diode 452, and the AC power supply (not illustrated) is connected with both terminals of the capacitor 454 via the diode bridge 456. This PFC circuit 450 outputs a direct current (DC) from both terminals of the capacitor 455.

### (Power source device)

Next, the power source device will be described according to the present embodiment. The power source device in the present embodiment includes HEMTs, or semiconductor devices according to one of the first to seventh embodiments.

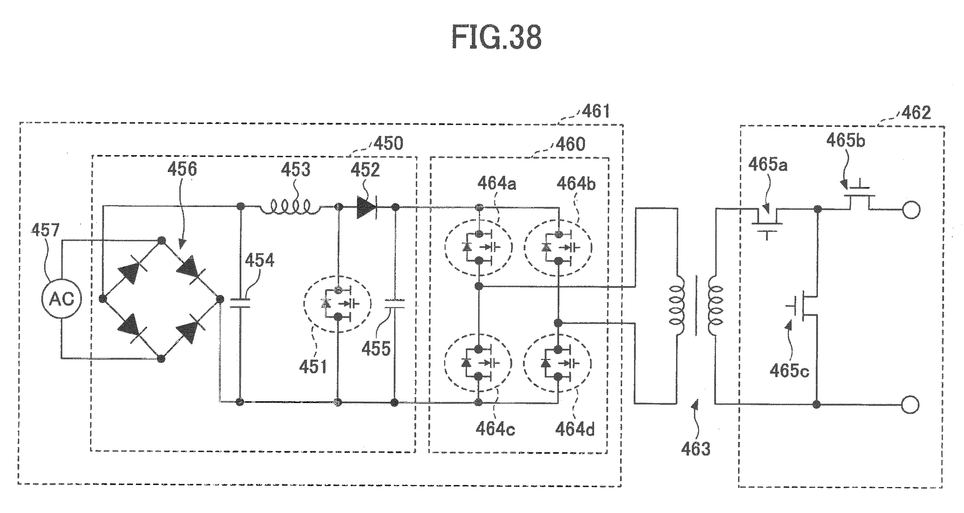

First, the power source device in the present embodiment will be described based on FIG. 38. The power source device in the present embodiment has a structure that includes a PFC circuit 450 in the present embodiment described above.

The power source device in the present embodiment includes a high-voltage primary circuit 461, a low-voltage secondary circuit 462, and a transformer 463 disposed between the primary circuit 461 and the secondary circuit 462.

The primary circuit 461 includes the PFC circuit 450, and an inverter circuit, for example, a full-bridge inverter circuit 460 connected with terminals of the capacitor 455 in the PFC circuit 450. The full-bridge inverter circuit 460 includes multiple (four in this example) switching elements 464a, 464b, 464c, and 464d. Also, the secondary circuit 462 includes multiple (three in this example) switching elements 465a, 465b, and 465c. Note that the diode bridge 456 is connected with an AC power supply 457.

In the PFC circuit 450 of the primary circuit 461 in the present embodiment, the switching element 451 includes a HEMT, or a semiconductor device according to one of the first to seventh embodiments. Further, the switching elements 464a, 464b, 464c, and 464d in the full-bridge inverter circuit 460 include HEMTs, respectively, that are semiconductor devices according to the first or second embodiment. On the other hand, the switching elements 465a, 465b, and 465c in the secondary circuit 462 use usual MISFETs (metal insulator semiconductor field effect transistor) formed of silicon, respectively.

### (High frequency amplifier)

Next, the high-frequency amplifier in the present embodiment will be described. The high frequency amplifier in the present embodiment has a structure including a HEMT, or a semiconductor device according to the first or second embodiment.

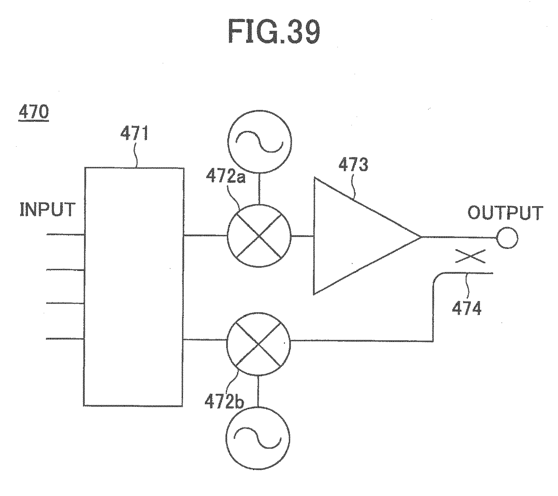

The high-frequency amplifier in the present embodiment will be described based on FIG. 39. This high-frequency amplifier 470 includes a digital predistortion circuit 471, mixers 472a and 472b, a power amplifier 473, and a directional coupler 474.

The digital predistortion circuit 471 compensates for non-linear distortion of an input signal. The mixer 472a mixes the input signal having non-linear distortion compensated, with an alternating current signal. The power amplifier 473 amplifies the input signal having been mixed with the alternating current signal, and includes a HEMT, or a semiconductor device according to one of the first to seventh embodiments. The directional coupler 474 monitors the input signal and an output signal. In the circuit illustrated in FIG. 39, by turning on/off a switch, for example, it is possible to mix the output signal with an alternating current signal by using the mixer 472b, and to transmit the mixed signal to the digital predistortion circuit 471.

The embodiments have been described in detail above. Further, the present invention is not limited to these embodiments, but various variations and modifications may be made without departing from the scope of the present invention.

## Claims

1. A semiconductor device comprising:
a first semiconductor layer (21) configured to be formed of a nitride semiconductor on a substrate (11);
a second semiconductor layer (22) configured to be formed of a nitride semiconductor on the first semiconductor layer;
an insulation film (30) configured to include an opening (30a), and to be formed on the second semiconductor layer;
a source electrode (42) and a drain electrode (43) configured to be formed on the second semiconductor layer; and
a gate electrode (41) configured to be formed at the opening on the second semiconductor layer,
wherein both the insulation film and the second semiconductor layer include carbon in a neighborhood of an interface between the insulation film and the second semiconductor layer.

2. A semiconductor device comprising:
a first semiconductor layer (21) configured to be formed of a nitride semiconductor on a substrate;
a second semiconductor layer (22) configured to be formed of a nitride semiconductor on the first semiconductor layer;
a third semiconductor layer (23) configured to be formed of a nitride semiconductor on the second semiconductor layer;
an insulation film (30) configured to include an opening (30a), and to be formed on the third semiconductor layer;
a source electrode (42) and a drain electrode (43) configured to be formed on the second semiconductor layer; and
a gate electrode (41) configured to be formed at the opening on the third semiconductor layer,
wherein both the insulation film and the third semiconductor layer include carbon in a neighborhood of an interface between the insulation film and the third semiconductor layer.

3. The semiconductor device as claimed in claim 2, wherein the third semiconductor layer is formed of a material including GaN.

4. The semiconductor device as claimed in any one of claims 1 to 3, wherein the first semiconductor layer is formed of a material including GaN.

5. The semiconductor device as claimed in any one of claims 1 to 4, wherein the second semiconductor layer is formed of a material including one of AlGaN, InGaAlN, and InAlN.

6. The semiconductor device as claimed in any one of claims 1 to 5, wherein the insulation film is formed of a material including one of SiN, SiO₂, SiC, SiON, SiCN, SiCO, AlN, Al₂O₃, and AlON.

7. The semiconductor device as claimed in any one of claims 1 to 6, wherein carbon included in the insulation film is bonded with silicon or aluminum included in the insulation film.

8. The semiconductor device as claimed in any one of claims 1 to 7, wherein the insulation film is formed by stacking a plurality of the insulation films,
wherein one of the insulation films contacting the second semiconductor layer or the third semiconductor layer includes carbon.

9. The semiconductor device as claimed in claim 8, wherein the one of the insulation films contacting the second semiconductor layer or the third semiconductor layer is formed of a material including SiC or SiCO.

10. The semiconductor device as claimed in any one of claims 1 to 7, wherein the gate electrode includes a gate electrode field plate formed on the insulation film,
wherein carbon is included in a region immediately below the gate electrode field plate on a side of the drain electrode.

11. The semiconductor device as claimed in any one of claims 1 to 7, wherein the gate electrode includes a gate electrode field plate formed on the insulation film,
wherein carbon is included in a region immediately below the gate electrode, and immediately below the gate electrode field plate on a side of the drain electrode.

12. A manufacturing method of a semiconductor device, the method comprising:
forming a first semiconductor layer (21) and a second semiconductor layer (22) made of a nitride semiconductor in order on a substrate (11);
carbonizing a surface of the second semiconductor layer;
forming an insulation film (30) on the second semiconductor layer;
forming an opening (30a) in the insulation film;
forming a gate electrode (41) at the opening on the second semiconductor layer; and
forming a source electrode (42) and a drain electrode (43) on the second semiconductor layer.

13. A manufacturing method of a semiconductor device, the method comprising:
forming a first semiconductor layer (21), a second semiconductor layer (22) and a third semiconductor layer (23) made of a nitride semiconductor in order on a substrate (11);
carbonizing a surface of the third semiconductor layer;
forming an insulation film (30) on the third semiconductor layer;
forming an opening (30a) in the insulation film;
forming a gate electrode (41) at the opening on the third semiconductor layer; and
forming a source electrode (42) and a drain electrode (43) on the second semiconductor layer.

14. The manufacturing method of the semiconductor device as claimed in claim 12 or 13, wherein the carbonization is performed in an atmosphere including one of carbon dioxide, carbon monoxide, methane, ethane, and ethylene, by applying heat at a temperature of 400 °C to 1000 °C.

15. The manufacturing method of the semiconductor device as claimed in any one of claims 12 to 14, wherein the carbonization is performed at a same time when heat treatment for making ohmic contacts is performed in the forming of the source electrode and the drain electrode.

16. The manufacturing method of the semiconductor device as claimed in any one of claims 12 to 14, wherein the carbonization is performed before the forming of the source electrode and the drain electrode.

17. The manufacturing method of the semiconductor device as claimed in any one of claims 12 to 14, wherein the carbonization is performed after the forming of the source electrode and the drain electrode.

18. The manufacturing method of the semiconductor device as claimed in any one of claims 12 to 17, wherein the gate electrode includes a gate electrode field plate (41a) formed on the insulation film,
wherein, between the carbonization and the forming the insulation film, removing a layer is performed for the layer including carbon so that the layer is removed except for a region immediately below the gate electrode field plate on a side of the drain electrode.

19. The manufacturing method of the semiconductor device as claimed in any one of claims 12 to 17, wherein the gate electrode includes a gate electrode field plate (41a) formed on the insulation film,
wherein, between the carbonization and the forming the insulation film, removing a layer is performed for the layer including carbon so that the layer is removed except for a region immediately below the gate electrode, and immediately below the gate electrode field plate on a side of the drain electrode.

20. The manufacturing method of the semiconductor device as claimed in claim 12 or 13, wherein the forming the insulation film includes
forming a first insulation film (131), and forming a second insulation film (132) on the first insulation film,
wherein the first insulation film is made of SiCO or SiC, and formed by CVD.

21. A manufacturing method of a semiconductor device, the method comprising:
forming a first semiconductor layer (21) and a second semiconductor layer (22) made of a nitride semiconductor in order on a substrate (11);
performing ion implantation of carbon on a surface of the second semiconductor layer;
forming an insulation film (30) on the second semiconductor layer;
forming an opening (30a) in the insulation film;
forming a gate electrode (41) at the opening on the second semiconductor layer; and
forming a source electrode (42) and a drain electrode (43) on the second semiconductor layer,
wherein the gate electrode includes a gate electrode field plate (41a) formed on the insulation film,
wherein a region including carbon due to the ion implantation is formed immediately below the gate electrode field plate on a side of the drain electrode.

22. A manufacturing method of a semiconductor device, the method comprising:
forming a first semiconductor layer (21) and a second semiconductor layer (22) made of a nitride semiconductor in order on a substrate (11);
performing ion implantation of carbon on a surface of the second semiconductor layer;
forming an insulation film (30) on the second semiconductor layer;
forming an opening (30a) in the insulation film;
forming a gate electrode (41) at the opening on the second semiconductor layer; and
forming a source electrode (42) and a drain electrode (43) on the second semiconductor layer,
wherein the gate electrode includes a gate electrode field plate (41a) formed on the insulation film,
wherein a region including carbon due to the ion implantation is formed immediately below the gate electrode, and immediately below the gate electrode field plate on a side of the drain electrode.

23. A manufacturing method of a semiconductor device, the method comprising:
forming a first semiconductor layer (21), a second semiconductor layer (22) and a third semiconductor layer (23) made of a nitride semiconductor in order on a substrate (11);
performing ion implantation of carbon on a surface of the third semiconductor layer;
forming an insulation film (30) on the third semiconductor layer;
forming an opening (30a) in the insulation film;
forming a gate electrode (41) at the opening on the third semiconductor layer; and
forming a source electrode (42) and a drain electrode (43) on the second semiconductor layer,
wherein the gate electrode includes a gate electrode field plate (41a) formed on the insulation film,
wherein a region including carbon due to the ion implantation is formed immediately below the gate electrode field plate on a side of the drain electrode.

24. A manufacturing method of a semiconductor device, the method comprising:
forming a first semiconductor layer (21), a second semiconductor layer (22) and a third semiconductor layer (23) made of a nitride semiconductor in order on a substrate (11);
performing ion implantation of carbon on a surface of the third semiconductor layer;
forming an insulation film (30) on the third semiconductor layer;
forming an opening (30a) in the insulation film;
forming a gate electrode (41) at the opening on the third semiconductor layer; and
forming a source electrode (42) and a drain electrode (43) on the second semiconductor layer,
wherein the gate electrode includes a gate electrode field plate (41a) formed on the insulation film,
wherein a region including carbon due to the ion implantation is formed immediately below the gate electrode, and immediately below the gate electrode field plate on a side of the drain electrode.

25. The manufacturing method of the semiconductor device as claimed in any one of claims 12 to 19, wherein the insulation film is formed of a material including one of SiN, SiO₂, SiC, SiON, SiCN, SiCO, AlN, Al₂O₃, and AlON.

26. The manufacturing method of the semiconductor device as claimed in claim 13, wherein the third semiconductor layer is formed of a material including GaN.

27. The manufacturing method of the semiconductor device as claimed in any one of claims 12 to 26, wherein the second semiconductor layer is formed of a material including one of AlGaN, InGaAlN, and InAlN.

28. A power source device (461, 462, 463) comprising the semiconductor device as claimed in any one of claims 1 to 11.

29. An amplifier (470) comprising the semiconductor device as claimed in any one of claims 1 to 11.
